(19) **Europäisches Patentamt / European Patent Office / Office européen des brevets**

(11) **EP 4 256 407 B1**

(12) **EUROPEAN PATENT SPECIFICATION**

(45) Date of publication and mention
of the grant of the patent:
**05.03.2025 Bulletin 2025/10**

(21) Application number: **21835095.7**

(22) Date of filing: **07.12.2021**

(51) International Patent Classification (IPC):
**G05B 13/04** $^{(2006.01)}$    **G05B 17/02** $^{(2006.01)}$

(52) Cooperative Patent Classification (CPC):
**G05B 13/048; G05B 17/02**

(86) International application number:
**PCT/US2021/062172**

(87) International publication number:
**WO 2022/125526 (16.06.2022 Gazette 2022/24)**

(54) **SYSTEMS AND METHODS FOR DIGITAL TWINNING OF A HYDROCARBON SYSTEM**

SYSTEME UND VERFAHREN ZUR DIGITALEN ZWILLINGBILDUNG EINES KOHLENWASSERSTOFFSYSTEMS

SYSTÈMES ET PROCÉDÉS DE JUMELAGE NUMÉRIQUE D'UN SYSTÈME D'HYDROCARBURES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.12.2020 US 202063122325 P**

(43) Date of publication of application:
**11.10.2023 Bulletin 2023/41**

(73) Proprietor: **SENSIA LLC**
**Houston, TX 77079 (US)**

(72) Inventors:
• **CHONG, Jonathan**
  **Richmond, Texas 77407 (US)**
• **HOEFEL, Albert**
  **Sugar Land, Texas 77479 (US)**
• **NGUYEN, Nam**
  **Houston, Texas 77096 (US)**
• **JIN, Rongzhen**
  **Houston, Texas 77077 (US)**

• **AGRAWAL, Shivam**
  **Houston, Texas 77024 (US)**
• **SUBERVIE, Yves-Marie**
  **Houston, Texas 77055 (US)**

(74) Representative: **Gill Jennings & Every LLP**
**The Broadgate Tower**
**20 Primrose Street**
**London EC2A 2ES (GB)**

(56) References cited:
**WO-A1-2018/165352     US-A1- 2017 286 572**

• **AVERSANO GIANMARCO ET AL: "Digital twin of a combustion furnace operating in flameless conditions: reduced-order model development from CFD simulations", PROCEEDINGS OF THE COMBUSTION INSTITUTE, ELSEVIER, NL, vol. 38, no. 4, 30 September 2020 (2020-09-30), pages 5373 - 5381, XP086536256, ISSN: 1540-7489, [retrieved on 20200930], DOI: 10.1016/ J.PROCI.2020.06.045**

**Description**

**BACKGROUND**

The present disclosure relates to modelling a hydrocarbon system. More particularly, the present disclosure relates to real-time model based analysis and control of a hydrocarbon system.

**SUMMARY**

The invention is defined in the appended claims.

One implementation of the present disclosure is a method for generating and using a digital twin of a hydrocarbon system, according to some embodiments. In some embodiments, the method includes performing a plurality of simulations using design of experiments (DOE) techniques to create a hyperdimensional space mapping simulation inputs, outputs and attributes. In some embodiments, the method includes using the hyperdimensional space from the plurality of simulations to generate one or more reduced order models (ROMs) using a regression technique or a machine learning technique. In some embodiments, the method includes generating a digital twin of the hydrocarbon system by instantiating the one or more ROMs at an operational point of the hydrocarbon system, and configuring the digital twin to use real-time data obtained from the hydrocarbon system. In some embodiments, the method includes estimating values of one or more variables of the hydrocarbon system in real-time using the digital twin. In some embodiments, the method includes controlling the hydrocarbon system based on the estimated values of the one or more variables.

In some embodiments, the one or more ROMs include a forward ROM, an inverse ROM, or a calibration ROM. In some embodiments, the forward ROM is configured to predict values of one or more variables of the system for a hypothetical scenario based on values of one or more controllable variables, values of one or more configuration parameters, and values of one or more calibration variables.

In some embodiments, the inverse ROM is configured to solve an inversion problem to estimate values of one or more system variables of the hydrocarbon system based on values of one or more controllable variables, values of one or more configuration parameters, values of one or more calibration variables, and values of one or more measured variables of the hydrocarbon system.

In some embodiments, the calibration ROM is configured to estimate one or more calibration variables for the forward ROM and the inverse ROM based on values of one or more controllable variables, values of one or more configuration parameters, values of one or more unmeasurable variables, and values of one or more measured variables. In some embodiments, the digital twin includes an instantiation of a plurality of ROMs, wherein one or more of the plurality of ROMs are configured to provide an output to a different ROM of the plurality of ROMs as an input.

In some embodiments, the method further includes performing an on-site test at the hydrocarbon system to obtain calibration data. In some embodiments, the method includes, at least one of (1) re-generating the one or more ROMs and re-generating the digital twin using the calibration data to generate a calibrated digital twin, or (2) providing the calibration data to a calibration ROM for use in updating one or more other ROMs of the digital twin.

In some embodiments, the re-generation includes an automated selection of an optimal combination of both a DOE sampling scheme, and ROM model and parameters, simultaneously in the presence of calibration measurements and a calibration match criteria. In some embodiments, the re-generation includes an iterative process and a Bayesian regularization technique.

Another implementation of the present disclosure is a system for generating and using a digital twin of a hydrocarbon system, according to some embodiments. In some embodiments, the system includes a processor. In some embodiments, the processor is configured to perform a plurality of simulations in a hyperdimensional space to generate outputs. In some embodiments, the processor is configured to use the outputs of the plurality of simulations to generate one or more reduced order models (ROMs) using a regression technique or a machine learning technique. In some embodiments, the processor is configured to generate a digital twin of the hydrocarbon system by instantiating the one or more ROMs at an operational point of the hydrocarbon system, and configuring the digital twin to use real-time data obtained from the hydrocarbon system. In some embodiments, the processor is configured to operate the hydrocarbon system based on outputs of the digital twin.

In some embodiments, the processor is further configured to estimate values of one or more variables of the hydrocarbon system in real-time using the digital twin and real-time data. In some embodiments, the real-time data includes at least one of a wellhead pressure, a flow line pressure, an injection pressure, an injection rate, a pump discharge pressure, a pump intake pressure, a voltage, a current, or a motor temperature of the hydrocarbon system.

In some embodiments, the processor is configured to perform an automatic calibration check of the digital twin. In some embodiments, performing the automatic calibration check includes obtaining measurements of one or more predictor variables of the hydrocarbon system, determining one or more quasi-static parameters using the measurements of the one or more predictor variables, and determining if the one or more quasi-static parameters have converged. In some embodiments, in response to determining that the one or more quasi-static parameters have not converged, the processor is configured to adjust one or more of the predictor variables and re-determine the one or more quasi-static parameters and re-determine if the one or more quasi-static parameters have converged.

In some embodiments, the processor is configured to perform an automatic calibration check of the digital twin. In some embodiments, performing the automatic calibration check includes obtaining measurements of one or more predictor variables of the hydrocarbon system, determining one or more quasi-static parameters using the measurements of the one or more predictor variables, determining a predicted response using the one or more quasi-static parameters, comparing the predicted response to an actual response of the hydrocarbon system to determine a prediction error of the response, and minimizing the prediction error by adjusting the quasi-static parameters and re-determining the predicted response, and re-comparing the predicted response to the actual response to determine the prediction error of the response.

In some embodiments, at least one of the ROMs of the digital twin is a transient ROM. In some embodiments, the transient ROM includes a filter function, the parameters of the filter function being one or more quasi-static parameters output by a calibration ROM. In some embodiments, the filter function is configured to use deconvolution and the filter function to determine a predicted response given an input of one or more measurements of the hydrocarbon system.

In some embodiments, the processor is configured to use a plurality of measurements from a first data source, and data of the operational point from a second data source to instantiate the one or more ROMs of the digital twin. In some embodiments, the plurality of measurements from the first data source and the data of the operational point are temporally synchronized with each other.

In some embodiments, the processor is configured to automatically temporally synchronize the plurality of measurements from the first data source, and the data of the operational point from the second data source. In some embodiments, the processor is configured to instantiate the one or more ROMs using a plurality of data of the operational point of the hydrocarbon system, each of the plurality of data of the operational point having a weighting indicating a confidence factor of each of the plurality of data of the operational point.

In some embodiments, the processor is configured to re-calculate parameters of the one or more ROMs over time and monitor changes of the parameters of the one or more ROMs. In some embodiments, the processor is configured to alert a technician in response to the parameters of the one or more ROMs changing by more than a threshold amount.

Another implementation of the present disclosure is a twinning tool for generating and using a digital twin of a hydrocarbon system, according to some embodiments. In some embodiments, the twinning tool includes processing circuitry configured to perform a plurality of simulations using design of experiments (DOE) techniques to create a hyperdimensional space mapping simulation inputs, outputs and attributes. In some embodiments, the processing circuitry is configured to use the hyperdimensional space from the plurality of simulations to generate a plurality of reduced order models (ROMs) using a curve-fitting technique. In some embodiments, the processing circuitry is configured to determine a plurality of quasi-static parameters by providing calibration data obtained from performing a test at the hydrocarbon system as inputs to the plurality of ROMs. In some embodiments, the processing circuitry is configured to generate a digital twin of the hydrocarbon system based on the plurality of quasi-static parameters and the plurality of ROMs. In some embodiments, the processing circuitry is configured to predict a response of the hydrocarbon system over a future time horizon using the digital twin, and display the predicted response of the hydrocarbon system over the future time period to a technician.

BRIEF DESCRIPTION OF THE DRAWINGS

The disclosure will become more fully understood from the following detailed description, taken in conjunction with the accompanying figures, wherein like reference numerals refer to like elements, in which:

FIG. 1 is a diagram of a system for generating a digital twin of a hydrocarbon system based on one or more reduced order models (ROMs), according to some embodiments;

FIG. 2 is a flow diagram of a process for generating a digital twin of a hydrocarbon system based on one or more ROMs, according to some embodiments;

FIG. 3 is a diagram of a forward ROM showing inputs and outputs of the forward ROM, according to some embodiments;

FIG. 4 is a diagram of an inverse ROM showing inputs and outputs of the inverse ROM, according to some embodiments;

FIG. 5 is a diagram of a calibration ROM showing inputs and outputs of the calibration ROM, according to some embodiments;

FIG. 6 is a diagram of a digital twin including a calibration ROM, an inverse ROM, and a forward ROM interacting with each other and providing outputs, according to some embodiments;

FIG. 7 is a block diagram of a system for generating and using a digital twin, according to some embodiments;

FIG. 8 is a diagram of an inverse ROM for an electric submersible pump (ESP) well, according to some embodiments;

FIG. 9 is a block diagram of a calibration ROM and an inverse ROM for the ESP well of FIG. 8, according to some embodiments;

FIG. 10 is a graph showing estimated flow and measured flow over time of the calibration ROM and the inverse ROM of FIG. 9, according to some embodiments;

FIG. 11 is a graph showing estimated water cut (WC) and measured WC over time of the calibration ROM and the inverse ROM of FIG. 9, according to some embodiments;

FIG. 12 is a graph showing estimated gas oil ratio (GOR) and measured GOR over time of the calibration ROM and the inverse ROM of FIG. 9, according to some embodiments;

FIG. 13 is a graph showing estimated pump leakage (PL) of the calibration ROM and the inverse ROM of FIG. 9, according to some embodiments;

FIG. 14 is a diagram of gas lift well, according to some embodiments;

FIG. 15 is a diagram of a forward ROM for the gas lift well of FIG. 14, according to some embodiments; and

FIG. 16 is a dashboard for presentation to a technician on a webpage, according to some embodiments.

FIG. 17 is a block diagram of the workflow of a calibration ROM, according to some embodiments.

FIG. 18 is a block diagram of the workflow for a first implementation of optimization of a calibration ROM, according to some embodiments.

FIG. 19 is a block diagram of the workflow for a second implementation of optimization of a calibration ROM, according to some embodiments.

FIG. 20 is a block diagram of the workflow of a transient ROM, according to some embodiments.

FIG. 21 is a graph illustrating synchronization of data for calibration of a digital twin, according to some embodiments.

FIG. 22 is a graph illustrating weighting of calibration data for a digital twin, according to some embodiments.

FIG. 23 is a graph illustrating various quasi-static parameters of a digital twin, tracked over time, according to some embodiments.

FIG. 24 is a block diagram of an optimization that can be implemented in place of a calibration ROM, according to some embodiments.

## DETAILED DESCRIPTION

Before turning to the FIGURES, which illustrate the exemplary embodiments in detail, it should be understood that the present application is not limited to the details or methodology set forth in the description or illustrated in the FIGURES. It should also be understood that the terminology is for the purpose of description only and should not be regarded as limiting.

## Overview

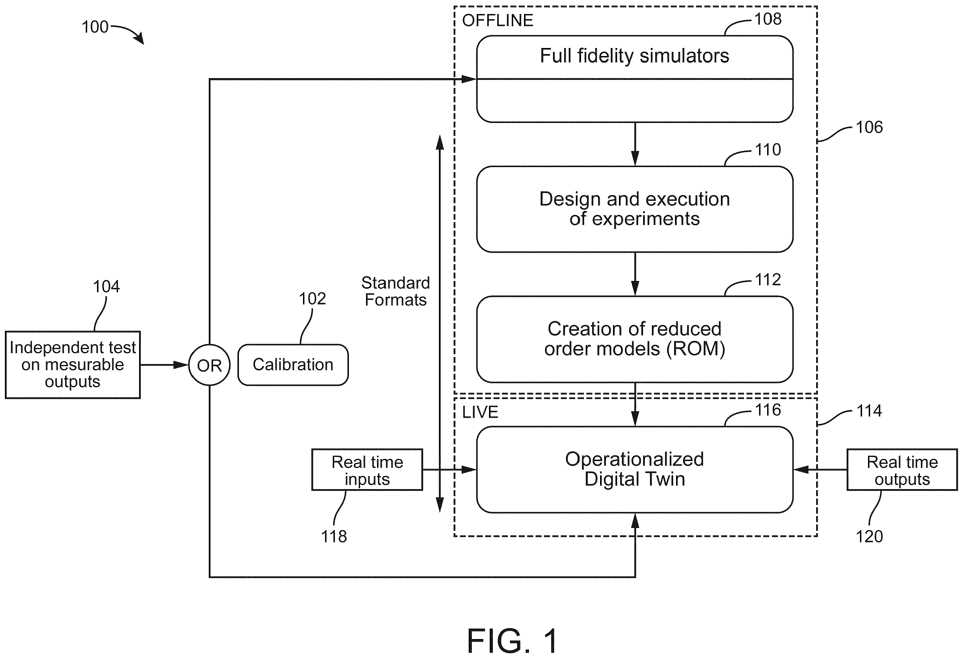

Referring particularly to FIG. 1, a diagram of a system 100 is shown for generating a digital twin 116 of a hydrocarbon, oil, or petroleum system, or a device of the system. System 100 can implement one or more offline techniques 106 and one or more online or live techniques 114 to generate the digital twin 116. The digital twin 116 may be an instantiation of one or more ROMs that digitally encapsulates necessary model attributes across an expected operating space as a system, and my include design, installation, and model variables. The digital twin 116 can be an instantiation of the ROMs at a particular point in time and may operate in real-time based on measurements and/or real-time information, shown as real-time inputs 118. The digital twin 116 can output real-time outputs 120 of any of the ROMs that are included in the digital twin 116. The digital twin 116 may be implemented as one of the live techniques 114 of the system 100, using real-time inputs 118 (e.g., sensor data, measurements, etc.) and outputting real-time outputs 120 (e.g., predicted values of one or more variables of a system, calculated values of one or more variables of the system, values of calibration variables of the system, etc.). The digital twin 116 may be configured to estimate or predict values of variables that are unmeasurable such as gas oil ratio (GOR), water cut (WC), liquid flow rate, etc. It should be understood that these particular unmeasurable variables are presented as an example and should not be understood as limiting.

The offline techniques 106 can include using one or more simulators 108 to perform a design and execution of experiments (DOE) 110. The simulators 108 and the DOE 110 can be multiple what-if scenarios in a hyperdimensional space (e.g., different values of speed of the pump or other parameters). For example, the simulators 108 may be different models, equations, operational curves, etc., of various components, sub-systems, or devices of the system that the digital twin 116 represents, and may also include various interrelationships (e.g., which models feed into each other, etc.) of the various components, sub-systems, devices, etc., of the system that the digital twin 116 represents. The simulators 108 and DOE 110 can use advanced techniques based on known information of the system that the digital twin 116 represents so that excessive numbers of simulations do not need to be simulated. For example, the simulations may be performed in a hyperdimensional space of various variables that the system which the digital twin 116 is to represent are expected to operate within. For example, if the system is a pump for a hydrocarbon system that is expected to operate at a pressure between 1000 and 3000 psi, the simulations may be performed for pressure in this range. In another example, if the system that the digital twin 116 represents is a hydrocarbon pump, the DOE 110 can simulate or estimate choke percentage, water output, etc., for different values of manipulated variables (e.g., speed or rpm of the system that the digital twin 116 represents), or different ranges of manipulated variables. The results of the DOE 110 may be operational or hypothetical (e.g., simulated operational) curves of different output variables of the system that the digital twin 116 represents, given different ranges or values of input variables. The DOE 110 may use Naive DOE techniques, or randomized DOE sampling techniques (e.g., latin hypercube DOE techniques, Sobol DOE techniques, Halton DOE techniques, etc.). In some embodiments, the randomized DOE sampling techniques overlap with operational range of all quantities of the digital twin to avoid extrapolation.

The results of the DOE 110 can be used to create ROMs, shown as ROM creation technique 112. The ROMs can be any of a transient ROM (e.g., a reduced order model that outputs multiple values of variables for a transient or dynamic phase of the system that the digital twin 116 represents), a static ROM, (e.g., a reduced order model that outputs static variables for a steady state phase of the system that the digital twin 116 represents), a forward ROM (e.g., a reduced order model that predicts future values or what-if scenarios of various variables for one or more control decisions), an inverse ROM (e.g., a reduced order model that can be used to solve an inversion problem and estimate different system parameters based on actual measurements and/or calibration variables), or a calibration ROM (e.g., a reduced order model that can be used to estimate or predict different calibration variables of the system that the digital twin 116 represents). Transient ROMs may be more complex than static or steady-state ROMs and may require additional elaboration or further techniques for generation, such as deconvolution, gradient search techniques, etc. In some embodiments, inputs to tROMs are quasi-static parameters or outputs of calibration ROMs. In some embodiments, the tROMs output predictions that are used to solve a deconvolution problem in order to estimate unmeasured or unmeasurable dynamic system variables. In some embodiments, tROMs also include convolutional neural networks. The ROMs can be generated using an advanced regression technique, a neural network, and/or or machine learning technique. For example, the ROMs can be generated based on the outputs of the DOE 110 using a linear regression technique, a Gaussian process regression technique, neural networks, XGBoost for regression, LGBoost, an autoselect (e.g., a Bayesian-based) regression technique, etc.

The digital twin 116 may be generated based on the one or more ROMs that are created when performing the ROM creation technique 112. For example, the digital twin 116 may include several of the ROMs and interrelationships between the ROMs (e.g., which ROM feeds an output to an input of a different ROM). In one example, the digital twin 116 includes a calibration ROM, an inverse ROM, and a forward ROM. Outputs of the calibration ROM can be provided to both the inverse ROM and the forward ROM. Outputs of the inverse ROM may be provided to the forward ROM.

The digital twin 116 includes one or more of the ROMs and can be instantiated at a particular point in time based on the real-time inputs 118, according to some embodiments. The outputs of the ROMs that define the digital twin 116 for the instantiation at the particular point in time can the real-time outputs 120 of the digital twin 116. In this way, the digital twin 116 operates based on real-time inputs 118 to provide real-time outputs 120, according to some embodiments.

Referring still to FIG. 1, a test 104 can be performed on measurable outputs of the system that the digital twin 116 represents. For example, the test 104 may be a well test if the system that the digital twin 116 represents is a hydrocarbon well pump. The test 104 can be performed by a technician or automatically at periodic intervals (e.g., every month, every six months, etc.). The test 104 can be performed to obtain different values of calibration variables or adjustments to the calibration variables of the system that the digital twin 116 represents. For example, if the digital twin 116 represents a hydrocarbon well pump, the calibration variables that are obtained by performing the test 104 can be Gas-oil-rate (GOR), Water Cut (WC), or a productivity index (PI) or reservoir pressure of the hydrocarbon system. The results of the test 104 (e.g., the calibration variables) can be used for a calibration 102 of the simulators 108 (e.g., to adjust, redefine, or update the simulators 108 based on real-world test results at the system that the digital twin 116 represents). The digital twin 116 can then be re-generated using the offline techniques 106 as described herein. In this way, the digital twin 116 can be intermittently or periodically re-calibrated in a non-real-time manner when the test 104 is performed and results of the test 104 are used to calibrate the simulators 108. Alternatively, the results of the test 104 can also be provided to the digital twin 116 for determining new settings for the calibration variables (e.g., a tested calibration of the system that the digital twin 116 represents), if those variables were exercised as part of the original DOE. The real-time outputs 120 of the digital twin 116 may be used in a variety of applications, including, but not limited to, simulations, model predictive control (MPC) or optimization, feedback control of the system that the digital twin 116 represents, or dashboards. In some embodiments, test or calibration measurements are needed to avoid under-determination of the regression problem of generating the ROMs or to compensate for inaccuracies of underlying measurements or estimations. In some embodiments, calibration can be achieved by reperforming the simulations with adjusted simulation input parameters, correcting inaccurate measurements or estimates, and/or determining an output parameter for an inverse or forward ROM from a calibration ROM or procedure.

**Forward ROM**

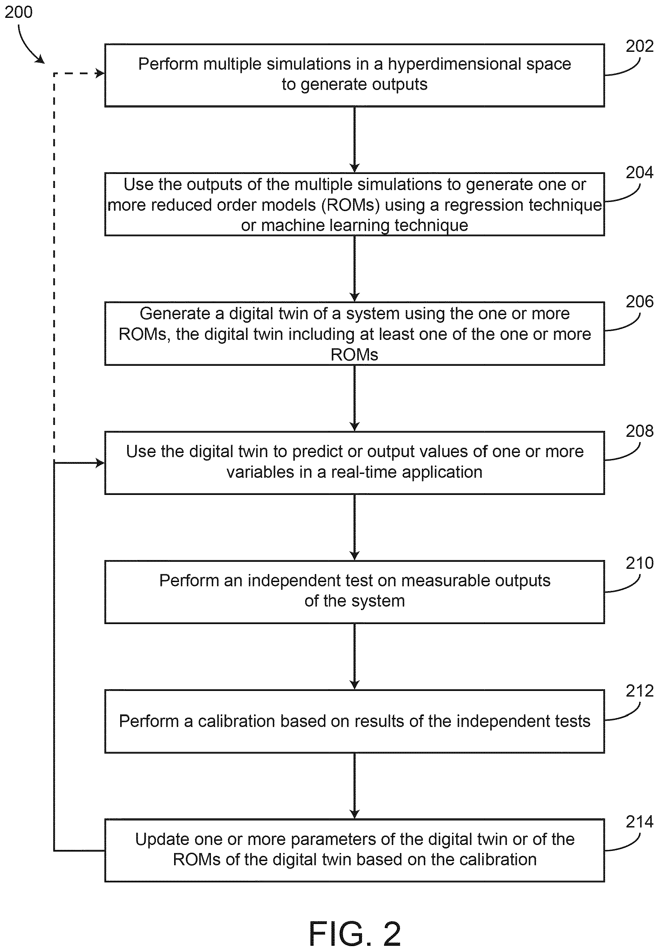

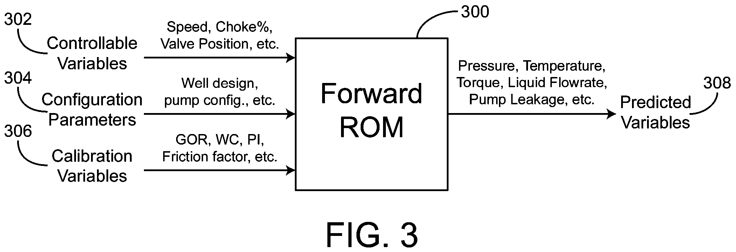

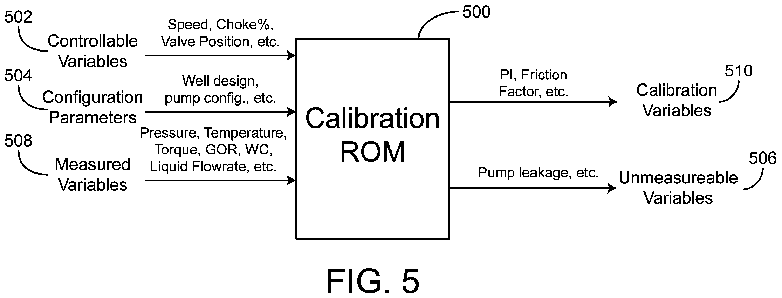

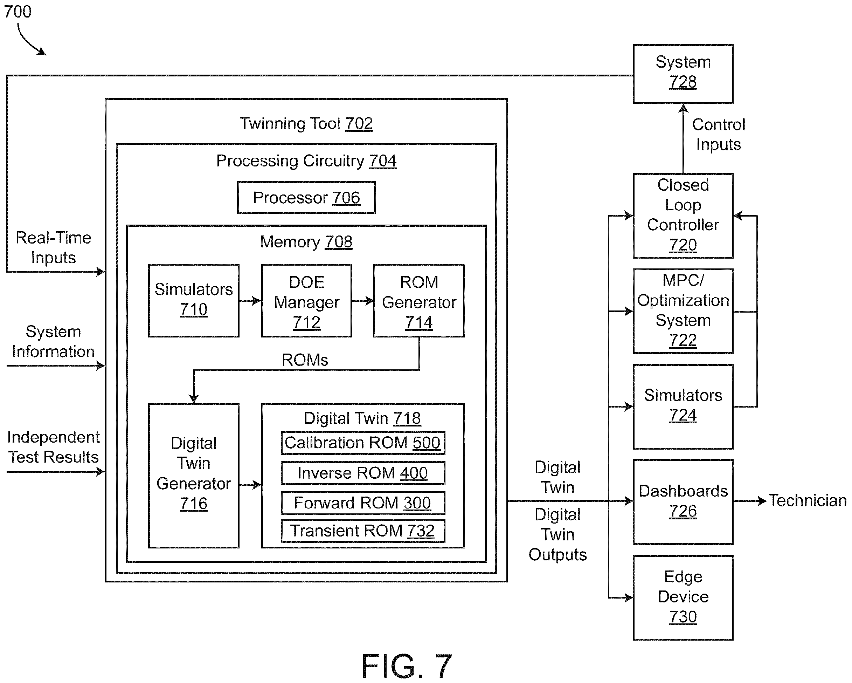

Referring now to FIG. 3, a forward ROM 300 that can be generated using the techniques described in greater detail above with reference to FIG. 1 (and in greater detail below with reference to FIG. 2 and FIG. 7) is shown, according to some embodiments. In some embodiments, the forward ROM 300 is configured to receive inputs of controllable variables 302, configuration parameters 304, and calibration variables 306. In some embodiments, the forward ROM 300 is configured to output one or more predicted variables 308 (e.g., given values of the controllable variables 302). The predicted variables 308 can be simulated values of the system that the digital twin 116 represents. The controllable variables 302 can be variables that represent an operational setting (e.g., an adjustable setting) of one or more actuators, motors, etc., or other controllable devices of the system that the digital twin 116 represents. The configuration parameters can be known parameters of the system that the digital twin 116 represents (e.g., well design, pump configuration, etc., if the system that the digital twin 116 represents is a hydrocarbon well pump). The calibration variables 306 may be outputs of a calibration ROM (e.g., calibration ROM 500 as described in greater detail below with reference to FIG. 5) or results from the test 104 (e.g., manual measurements).

The forward ROM 300 can generally have the form:

$$var_{predict} = f_{fwd}(var_{control}, var_{config}, var_{cal})$$

where $var_{predict}$ is multiple sets of time-series data of different variables that are predicted by the forward ROM 300, $var_{control}$ is multiple sets time-series data of different controllable variables (e.g., the controllable variables 302), $var_{config}$ is multiple sets of time-series data of different configuration parameters (e.g., the configuration parameters *304), var_{cal}* is multiple sets of time-series data of different calibration variables (e.g., the calibration variables 306), and $f_{fwd}$ is the forward ROM 300 (e.g., a function). If the system that the digital twin 116 represents is a hydrocarbon well pump, the controllable variables 302 may include pump speed, choke position/percent, valve position, etc., the configuration parameters 304 may be well design or pump configuration parameters, the calibration variables 306 may be GOR, WC, PI, friction factor, etc., variables, and the predicted variables 308 may be pressure, temperature, torque, liquid flow rate, pump leakage, etc. The forward ROM 300 can output values of the predicted variables 308 (e.g., a response of the system) given different inputs of the controllable variables 302 (e.g., an impact on pressure, temperature, torque, liquid flowrate, pump leakage, boundary conditions, etc., that will occur if the speed of the pump or the choke is adjusted).

**Inverse ROM**

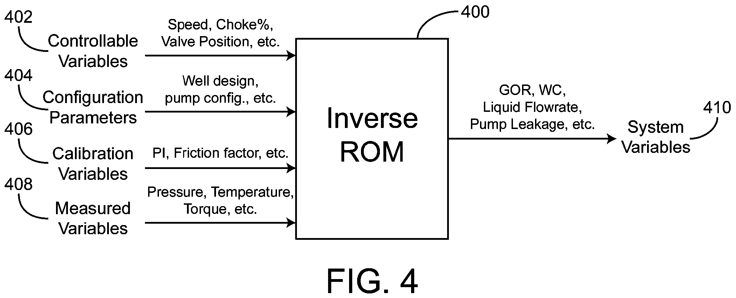

Referring now to FIG. 4, an inverse ROM 400 that can be generated using the techniques described in greater detail above with reference to FIG. 1 (and in greater detail below with reference to FIGS. 2 and 7) is shown, according to some embodiments. In some embodiments, the inverse ROM 400 is configured to receive inputs of controllable variables 402, configuration parameters 404, calibration variables 406, and measured variables 408. The controllable variables 402 may be the same as the controllable variables 302 as described in greater detail above with reference to FIG. 3. The configuration parameters 404 can be the same as the configuration parameters 304 as described in greater detail above with reference to FIG. 3. The calibration variables 406 can include some of the calibration variables 306 as described in greater detail above with reference to FIG. 4. The measured variables 408 can be any variables of the system that the digital twin 116 represents that can be obtained (e.g., in real-time) from one or more sensors of the system (e.g., pressure, temperature, torque, etc.).

The inverse ROM 400 is configured to solve an inversion problem to estimate or calculate system variables 410 for the system that the digital twin 116 represents based on the controllable variables 402, the configuration parameters 404, the calibration variables 406, and the measured variables 408. For example, given different control inputs, configuration of the system, calibration of the system, and sensor data of the system, the inverse ROM 400 can estimate values of the system variables 410 that the system had to result in the measured variables 408. For example, the system variables 410 can include GOR, WC, liquid flowrate, pump leakage, etc., or any other variable that is difficult to measure. Advantageously, the inverse ROM 400 allows the inference of various parameters that are difficult to measure or that cannot be measured in real-time. Such unmeasurable parameters can be valuable and usable in a control scheme for the system that the digital twin 116 represents.

The inverse ROM 400 can generally have the form:

$$var_{sys} = f_{inv}\big(var_{control}, var_{config}, var_{cal}, var_{meas}\big)$$

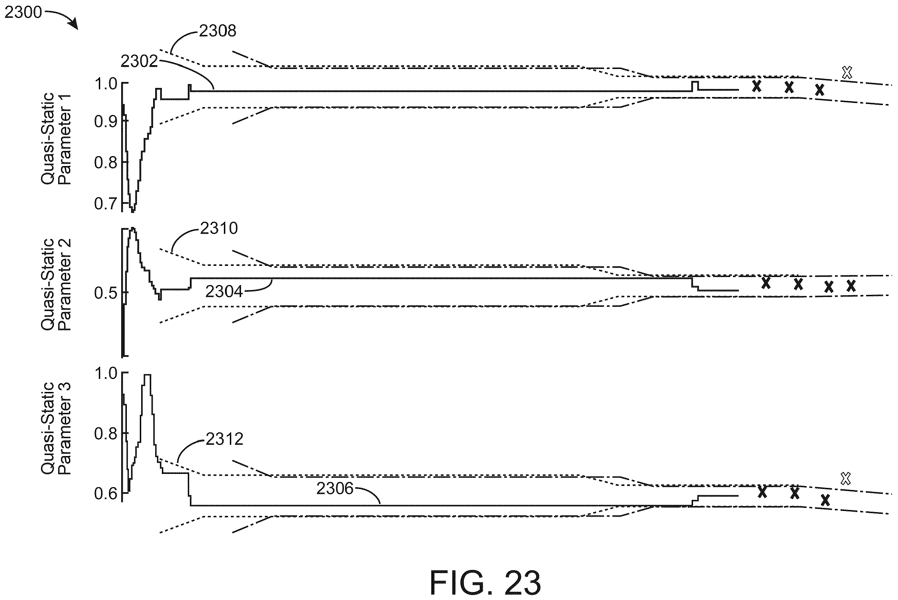

where $var_{sys}$ is multiple sets of time-series data of system variables that are estimated by the inverse ROM 400 (e.g., the system variables 410), $var_{control}$ is multiple sets of time-series data of different controllable variables (e.g., the controllable variables 402 or the controllable variables 302), $var_{config}$ is multiple sets of time-series data of different configuration parameters (e.g., the configuration parameters 404 or the configuration parameters 304), $var_{cal}$ is multiple sets of time-series data of different calibration variables (e.g., the calibration variables 406), $var_{meas}$ is multiple sets of time-series data of different measured variables (e.g., the measured variables 408), and $f_{inv}$ is the inverse ROM 400 (e.g., a function). The calibration variables 406 can include PI, friction factor, etc., and may be outputs of a calibration ROM (e.g., the calibration ROM 500 as described in greater detail below with reference to FIG 5) or may be values obtained from performing a test (e.g., the test 104). In some embodiments, the calibration variables 406 are subject to constraints, similarly to as shown in FIG. 23 and described in greater detail below.

## Calibration ROM

Referring now to FIG. 5, a calibration ROM 500 that can be generated using the techniques described in greater detail above with reference to FIG. 1 (and in greater detail below with reference to FIGS. 2 and 7) is shown, according to some embodiments. In some embodiments, the calibration ROM 500 is configured to receive inputs of controllable variables 502, configuration parameters 504, and measured variables 508. In some embodiments, the calibration ROM 500 is configured to output, predict, estimate, etc., calibration variables 510 and unmeasured variables 506. The controllable variables 502 may be the same as the controllable variables 402 or the controllable variables 302 as described in greater detail above with reference to FIGS. 3-4, according to some embodiments. The configuration parameters 504 may be the same as the configuration parameters 404 or the configuration parameters 304 as described in greater detail above with reference to FIGS. 3-4. The unmeasurable variables 506 can be variables that are difficult to measure, For example, the unmeasurable variables 506 may be or include an of the system variables 410 as described in greater detail above with reference to FIG. 4. The measured variables 508 can be or include measurement values obtained by performing the test 104 (e.g., GOR, WC, liquid flowrate, etc.) and can also include values that are measured by various sensors of the system that the digital twin 116 represents (e.g., pressure, temperature, torque, etc.). The calibration variables 510 can be estimated calibration factors or variables that are difficult to measure in real-time (e.g., PI, friction factor, etc.).

The calibration ROM 500 is configured to generate calibration values that can be used to update other calibration inputs of different ROMs of the digital twin 116 (e.g., the inverse ROM 400, the forward ROM 300, etc.). The calibration ROM 500 can generally have the form:

$$var_{cal}, var_{unmeas} = f_{cal}\big(var_{control}, var_{config}, var_{meas}\big)$$

where $var_{cal}$ is multiple sets of time-series data of calibration variables that are estimated by the calibration ROM 500 (e.g., the calibration variables 406 or a portion of the calibration variables 306), $var_{unmeas}$ is multiple sets of time-series data of different unmeasurable or system variables (e.g., the unmeasurable variables 506, the system variables 410) estimated by the calibration ROM 500, $var_{control}$ is multiple sets time-series data of different controllable variables (e.g., the controllable variables 502, the controllable variables 402 or the controllable variables 302), $var_{config}$ is multiple sets of time-series data of different configuration parameters (e.g., the configuration parameters 504, the configuration parameters 404 or the configuration parameters 304), and $f_{cal}$ is the calibration ROM 500 (e.g., a function). The outputs of the calibration ROM 500 can be provided as inputs to other ROMs of the digital twin 116 (e.g., the inverse ROM 400 and/or the forward ROM 300).

## Example Digital Twin

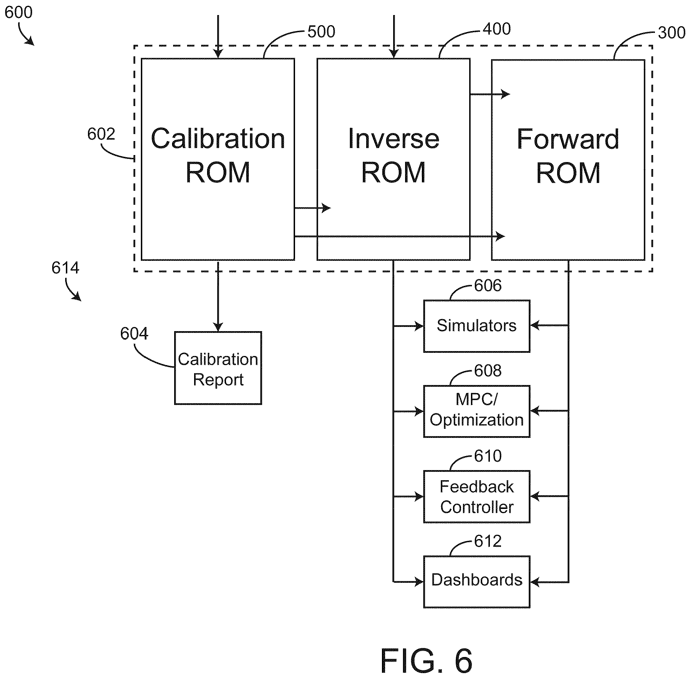

Referring now to FIG. 6, a diagram 600 shows interaction between a digital twin 602 and one or more applications 614, according to some embodiments. The digital twin 602 can be the same as or similar to the digital twin 116 and may be generated using similar techniques. The digital twin 602 includes the calibration ROM 500, the inverse ROM 400, and the forward ROM 300, according to some embodiments. Outputs of the calibration ROM 500 (e.g., the calibration variables 510) are provided to the inverse ROM 400 and the forward ROM 300 as inputs (e.g., as the calibration variables 306 and the calibration variables 406). The calibration ROM 500 can receive its inputs (e.g., the controllable variables 502, the configuration parameters 504, the unmeasurable variables 506, and the measured variables 508) from one or more external sources (e.g., from a controller of the system that the digital twin 602 represents such as the feedback controller 610, from sensors of the system that the digital twin 602 represents, results of a test performed at the system of the digital twin, known configuration or system settings, etc.). The inverse ROM 400 and the forward ROM 300 can also receive similar inputs from the one or more external sources.

The calibration ROM 500 also provides its outputs (e.g., the calibration variables 510) to a calibration report application 604. The calibration report application 604 can be an external application that is configured to generate a report for a technician to view (e.g., graphs, charts, values of the calibration variables 510, use of the calibration variables 510, etc.).

The inverse ROM 400 is configured to provide its outputs to the forward ROM 300, according to some embodiments. The inverse ROM 400 may also provide its outputs (e.g., the system variables 410) to the calibration ROM 500 for use in determining the calibration variables 510. For example, the inverse ROM 400 can provide the system variables 410 to the forward ROM 300. The inverse ROM 400 and the forward ROM 300 both provide their outputs (e.g., the system variables 410 and the predicted variables 308) to a simulation application 606, an MPC/optimization application 608, a feedback controller 610, or a dashboard 612. In this way, outputs of the digital twin 602 can be used to perform simulations, to perform MPC or optimization of the system that the digital twin 602 represents, to perform feedback or closed loop control (e.g., PID control) of the system that the digital twin 602 represents, and for data presentation on dashboards. In some embodiments, outputs of the MPC or optimization are provided to the inverse ROM 400, the forward ROM 300, or the calibration ROM 500 as inputs.

## Twinning Tool

Referring now to FIG. 7, the techniques described herein for the generation and use of a digital twin may be implemented in a twinning system 700 that includes a twinning tool 702 and various external applications. The twinning tool 702 is configured to generate a digital twin 718 and provide outputs of the digital twin 718 and/or the digital twin 718 itself to various external applications. As shown in FIG. 7, the twinning tool 702 includes processing circuitry 704 including a processor 706 and a memory 708. The processor 706 can be a general purpose or specific purpose processor, an application specific integrated circuit (ASIC), one or more field programmable gate arrays (FPGAs), a group of processing components, or other suitable processing components. The processor 706 may be configured to execute computer code and/or instructions stored in the memory 708 or received from other computer readable media (e.g., CDROM, network storage, a remote server, etc.).

The memory 708 can include one or more devices (e.g., memory units, memory devices, storage devices, etc.) for storing data and/or computer code for completing and/or facilitating the various processes described in the present disclosure. The memory 708 can include random access memory (RAM), read-only memory (ROM), hard drive storage, temporary storage, non-volatile memory, flash memory, optical memory, or any other suitable memory for storing software objects and/or computer instructions. The memory 708 can include database components, object code components, script components, or any other type of information structure for supporting the various activities and information structures described in the present disclosure. The memory 708 can be communicably connected to the processor 706 via the processing circuitry 704 and can include computer code for executing (e.g., by the processor 706) one or more processes described herein.

EP 4 256 407 B1

The memory 708 includes one or more simulators 710, a DOE manager 712, a ROM generator 714, a digital twin generator 716, and a digital twin 718, according to some embodiments. As shown in FIG. 7, the twinning tool 702 is configured to receive real-time inputs from a system 728 (e.g., the system that the digital twin 718 represents). The real-time inputs may be obtained from sensors, measurement devices, meters, flow meters, etc., of the system 728, according to some embodiments. The system 728 can be a hydrocarbon well pump, according to some embodiments. The twinning tool 702 is also configured to receive system information (e.g., from a technician, from a remote device, from a database, etc.), according to some embodiments. In some embodiments, the system information is meta-data regarding the system 728. In some embodiments, the system information is stored in the memory 708 of the twinning tool 702.

In some embodiments, the twinning tool 702 is also configured to receive independent test results (e.g., results of a test performed at the system 728 by a technician). A technician can perform a test at the system 728 (e.g., a well test) to obtain one or more measurements and provide the one or more measurements to the twinning tool 702 (e.g., via a user interface, a smartphone, a touchscreen device, etc.). It should be understood that the functionality of the twinning tool 702 can be implemented locally at the system 728 (e.g., on a single processing circuit) or may be implemented remotely and/or in a distributed manner (e.g., in a cloud computing system). For example, the twinning tool 702 can be cloud based such that the twinning tool 702 receives the real-time inputs, the system information, and the independent test results at a remote location, performs its functionality, and then provides outputs (e.g., the digital twin, the digital twin outputs, etc.) to one or more applications (e.g., a closed loop controller 720, an MPC/optimization system 722, one or more simulators 724, dashboards 726, edge devices 730, etc.) that are positioned locally at the system 728 or are positioned remotely from the system 728 in the cloud computing system.

The simulators 710 can be or include one or more functions, models, operational curves, etc., that represent different portions of the system 728, and/or one or more interrelationships of the one or more functions, models, operational curves, etc., of the different portions of the system 728 so that outputs of the system 728 can be simulated, according to some embodiments. The simulators 710 can be configured to implement a multi-variable or hyper-dimensional simulation of the system 728 to generate different outputs of the system 728 given different inputs of the system 728 (e.g., control inputs, temperature settings, flow rates, pump speed, etc., depending on a type of the system 728), according to some embodiments. For example, the simulators 710 may be configured to perform a high-fidelity simulation of the system 728. For example, the simulators 710 can include an electric submersible pump (ESP) simulator, a rod pump dynamic simulator, a pipe simulator, etc. The simulation outputs of the simulators 710 may be in the form of multi-dimensional graphs, curves, surface plots, etc., that express relationships between different variables (e.g., input and output variables of the system 728), according to some embodiments.

In some embodiments, the DOE manager 712 is configured to use the simulators 710 to implement the one or more simulations by performing one or more DOE techniques. The DOE techniques can include Naive DOE techniques, randomized DOE techniques, latin hypercube DOE techniques, Sobol DOE techniques, Halton DOE techniques, etc. The DOE manager 712 uses the simulators 710 to generate the simulation outputs and provides the simulation outputs to the ROM generator 714. For example, the DOE manager 712 can provide one or more multi-dimensional graphs to the ROM generator 714. The DOE manager 712 may implement any of the techniques of the DOE 110 as described in greater detail above with reference to FIG. 1.

The ROM generator 714 is configured to use the simulation outputs provided by the DOE manager 712 that are generated using the simulators 710 to generate one or more ROMs based on the simulation outputs, according to some embodiments. The ROMs can be generated by the ROM generator 714 using an advanced regression technique and the simulation outputs of the simulators 710, according to some embodiments. For example, the ROM generator 714 can be configured to use a linear regression technique, a Gaussian process regression technique, neural networks, machine learning techniques, a Bayesian-based regression technique, etc. The ROMs can include the calibration ROM 500, the inverse ROM 400, the forward ROM 300, or a transient ROM 732.

Referring still to FIG. 7, the digital twin generator 716 is configured to receive the ROMs from the ROM generator 714 and generate the digital twin 718 using the ROMs, according to some embodiments. The digital twin generator 716 is configured to instantiate the ROMs obtained from the ROM generator 714 using the real-time inputs, and define one or more interrelationships between the ROMs to generate the digital twin 718. In some embodiments, the digital twin 718 is or is similar to the digital twin 116 or the digital twin 602 as described in greater detail above. The digital twin 718 can be configured to estimate values of various calibration variables, system variables, and predicted variables. For example, if the system 728 is a hydrocarbon well pump, the digital twin 718 can be configured to output predicted variables such as: pressure of the hydrocarbon well pump, temperature of the hydrocarbon well pump, torque of the hydrocarbon well pump, liquid flowrate, pump leakage, etc., system variables such as: GOR, WC, liquid flowrate, pump leakage, etc., and/or calibration variables such as: PI, friction factor, etc.

The digital twin 718 is configured to provide any of the outputs discussed above (e.g., the predicted variables, the system variables, and/or the calibration variables, etc.) to one or more external applications such as the closed loop controller 720, the MPC/optimization system 722, the simulators 724, the dashboards 726, and/or the edge devices 730. It should be understood that this list is not exhaustive and that the digital twin 718 may provide its outputs to additional external applications. In some embodiments, the twinning tool 702 is configured to provide the digital twin 718 to any of the closed loop controller 720, the MPC/optimization system 722, the simulators 724, the dashboards 726, and/or the edge devices 730 for implementation and use of the digital twin 718 locally.

In some embodiments, the digital twin generator 716 is configured to calibrate the digital twin 718 based on the independent test results or calibration variables obtained by performing the independent test at the system 728. For example, the digital twin generator 716 may re-instantiate the digital twin 718 using the calibration variables obtained by performing the independent test at the system 728. In some embodiments, the simulators 710, the DOE manager 712, and the ROM generator 714 are configured to re-perform their functionality using the calibration variables of the independent test results to re-generate the ROMs. If the system 728 is a hydrocarbon well pump, the calibration variables obtained by performance of the independent test can be GOR, WC, and liquid flowrate.

The closed loop controller 720 is configured to use the digital twin outputs and/or the digital twin 718 to perform closed-loop control of the system 728, according to some embodiments. For example, the closed loop controller 720 can implement a PID control scheme to operate the system 728. The MPC/optimization system 722 can be configured to minimize, maximize, or otherwise optimize a cost function (e.g., a reward function) relative to one or more constraints by adjusting one or more control variables over a future time horizon, according to some embodiments. In some embodiments, the MPC/optimization system 722 may use the digital twin 718 for the system 728 as a model of the system 728, to estimate a value of the objective function, or to impose constraints on the objective function. In some embodiments, the MPC/optimization system 722 is configured to determine high-level control decisions for the system 728, and may provide the high-level control decisions to the closed loop controller 720. In some embodiments, the dashboards 726 are configured to use to digital twin and/or the digital twin outputs to generate dashboards for a technician and provide the dashboards to the technician.

Process

Referring to FIG. 2, a flow diagram of a process 200 for generating a digital twin based on one or more ROMs is shown, according to some embodiments. Process 200 includes steps 202-214, and can be performed by system 100 or by the twinning tool 702. Process 200 advantageously can be implemented to generate a digital twin of a system (e.g., a hydrocarbon well pump) that has a reduced complexity when compared to various other simulations. The digital twin may be implemented or used in various applications such as a closed loop or feedback controller of a system that the digital twin represents, an MPC or optimization system, one or more simulators, a dashboard, and/or an edge device.

Process 200 includes performing multiple simulations in a hyperdimensional space to generate outputs (step 202), according to some embodiments. In some embodiments, step 202 is configured to perform simulations using the simulators 710. In some embodiments, step 202 is performed by DOE manager 712 and simulators 710. Results of the simulations may include multi-dimensional graphs, surface plots, etc., showing relationships between different variables of the system that the digital twin represents.

Process 200 includes using the outputs of the multiple simulations to generate one or more reduced order models (ROMs) using a regression or machine learning technique (step 204), according to some embodiments. In some embodiments, step 204 is performed by the ROM generator 714 using any of the techniques described in greater detail above with reference to FIG. 7. In some embodiments, the ROMs include a calibration ROM, an inverse ROM, a forward ROM, and/or a transient ROM. The calibration ROM can be configured to estimate one or more configuration parameters (e.g., PI, friction factor, etc.), according to some embodiments. In some embodiments, the inverse ROM is configured to estimate one or more system variables (e.g., GOR, WC, liquid flowrate, pump leakage, etc.). For example, the inverse ROM can be configured solve an inversion problem and may receive various controllable variables, configuration parameters, calibration variables, and measured variables for a specific condition of the system and estimate system variables that must have been the case to achieve the measured variables, and the controllable variables, according to some embodiments. In some embodiments, the forward ROM is configured to predict or estimate predicted variables (e.g., measureable variables, system variables, etc.) given specific conditions (e.g., given different values of controllable variables, configuration parameters, or calibration variables).

Process 200 includes generating a digital twin of the system using the one or more ROMs, the digital twin including at least one of the one or more ROMs (step 206), according to some embodiments. In some embodiments, the digital twin is the digital twin 116, the digital twin 602, etc., or any other digital twin described herein. Step 206 can be performed by the digital twin generator 716 of the twinning tool 702, according to some embodiments. The digital twin can include the forward ROM, the inverse ROM, and/or the calibration ROM, and may include an interrelationship between the ROMs so that outputs of certain ROMs are fed into other ROMs as inputs, according to some embodiments. In some embodiments, the digital twin is an instantiation of the one or more ROMs and uses real-time data (e.g., sensor data) from the system that it represents. In this way, steps 202-206 may be performed off-line, while the ROM is used online with real-time data.

Process 200 includes using the digital twin to predict or output values of one or more variables of the system in a real-time application (step 208), according to some embodiments. In some embodiments, the digital twin is implemented in an on-line mode and is configured to receive real-time data from the system that it represents. The real-time data that the digital twin receives may depend on a particular application of the digital twin, according to some embodiments. The digital twin can use the ROMs to output different sets of variables including predicted variables, system variables, and calibration variables, according to some embodiments. In some embodiments, the predicted variables include pressure, temperature, torque, liquid flowrate, and pump leakage of the system that the digital twin represents. In some embodiments, the system variables include GOR, WC, liquid flow rate, and pump leakage of the system that the digital twin represents. In some embodiments, the calibration variables include PI and friction factor.

Process 200 includes performing an independent test on measurable outputs of the system that the digital twin represents (step 210), according to some embodiments. In some embodiments, for example, if the system is a hydrocarbon well pump, the test may be a well test to measure GOR, WC, and liquid flowrate of the hydrocarbon well pump. In some embodiments, step 210 is performed by a technician at the system that the digital twin represents. A well test can include updating one or more calibration knobs or quasi-static parameters of the digital twin.

Process 200 includes performing a calibration based on results of the independent test (step 212), according to some embodiments. In some embodiments, step 212 is performed by digital twin generator 716 by providing new calibration values as inputs to the various ROMs of the digital twin. In some embodiments, step 212 is performed by the simulators 710, the DOE manager 712, and the ROM generator 714 to re-generate the ROMs based on new calibration values that are obtained.

Process 200 includes updating one or more parameters of the digital twin or of the ROMs of the digital twin based on the calibration (step 214), according to some embodiments. Step 214 can be performed by the simulators 710, the DOE manager 712, and the ROM generator 714, according to some embodiments. In response to performing step 214, process 200 can return to step 208, or alternatively to step 202. It should be understood that steps 210-214 (or alternatively steps 202-214) may be performed in a non-real time basis (e.g., every month, every six months, etc.). In some embodiments, steps 212-214 (or steps 202-214) are only performed in response to step 210 if the independent test that is performed indicates that the digital twin needs to be re-calibrated.

**Example Implementations**

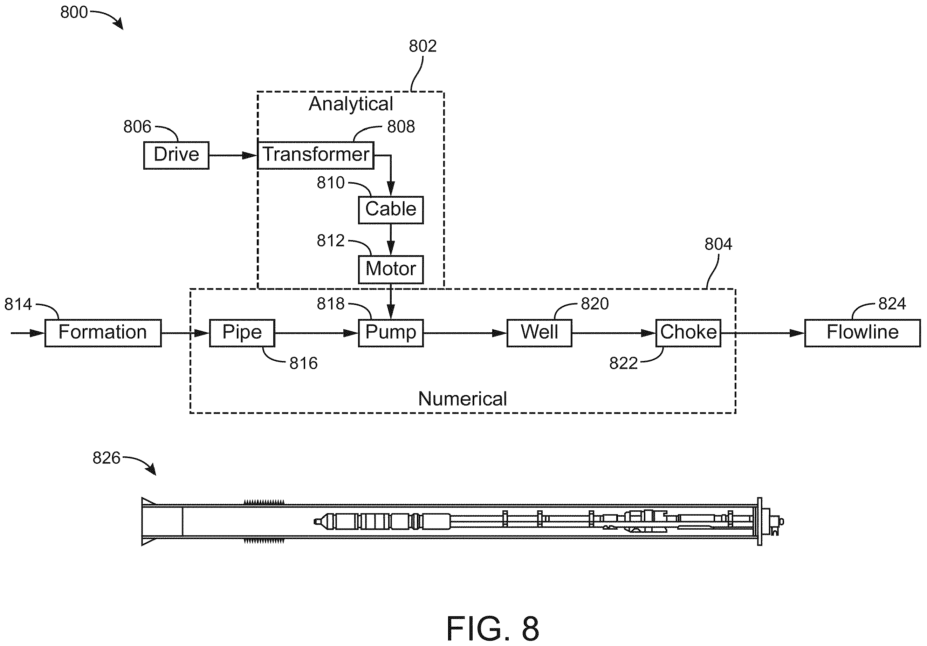

Referring now to FIG. 8, the systems and methods described herein can be implemented to generate a digital twin or an inverse ROM for an ESP well 826, according to some embodiments. Diagram 800 shows an example configuration of different simulation models or simulators that can be used to generate the inverse ROM for the ESP well 826, according to some embodiments. In some embodiments, the inverse ROM for the ESP well 826 includes one or more analytical models 802 and one or more numerical models 804, a drive model 806, a formation model 814, and a flowline model 824. The analytical models 802 include a transformer model 808, a cable model 810, and a motor model 812, according to some embodiments. The numerical models 804 include a pipe model 816, a pump model 818, a well model 820, and a choke model 822, according to some embodiments. In some embodiments, the different models described herein use variables or parameters such as voltage, current, frequency, speed, torque, density, viscosity, formation pressure, productivity index (PI), derating, intake temperature, intake pressure, in flow, output wellhead pressure, flow, WC, and GOR.

In some embodiments, one or more of the variables or parameters are measured values (e.g., measured and provided to a digital twin as real-time data). In some embodiments, one or more of the variables or parameters are obtained by performing a hyperdimensional simulation (e.g., performed when generating the inverse ROM). In some embodiments, one or more of the variables or parameters can be obtained by performing an on-site test, or can be determined by a calibration ROM. In some embodiments, one or more of the variables or parameters are measured values or set values (e.g., known or fixed values).

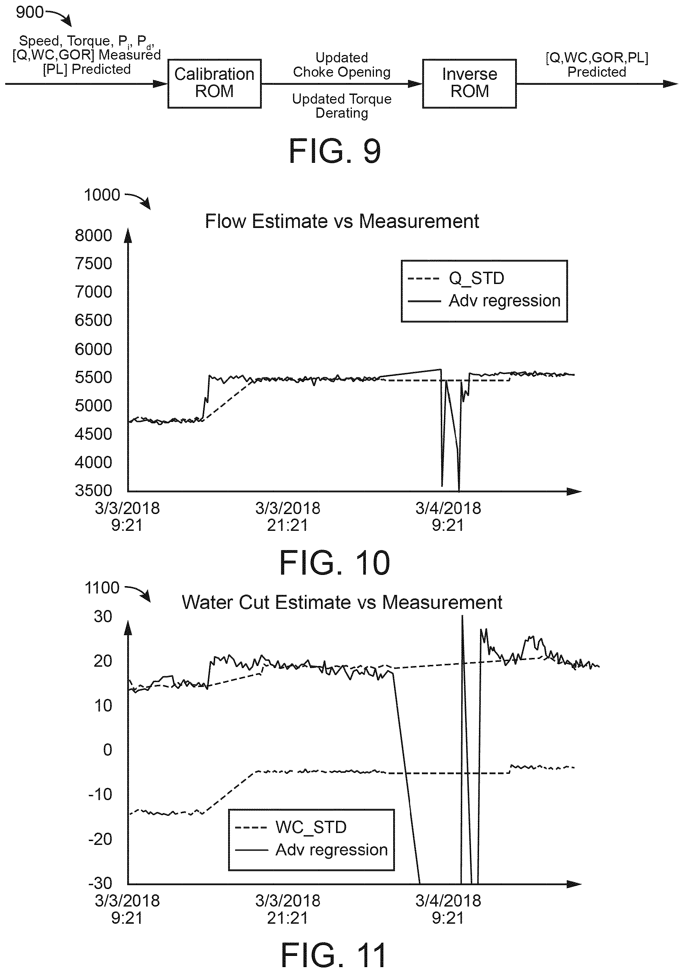

Referring now to FIG. 9, a diagram 900 shows a calibration ROM 902 and an inverse ROM 904 that function together to model an ESP well (e.g., the ESP well 826), according to some embodiments. The calibration ROM 902 receives inputs of speed, torque, $P_i$ and $P_d$ (e.g., values of a PID control scheme), measured values of flowrate Q, WC, and GOR, and predicted pump leakage (PL), according to some embodiments. Using these inputs the calibration ROM 902 outputs calibration variables including an updated choke opening and an updated torque derating, according to some embodiments. The calibration variables are provided as inputs to the inverse ROM 904, which uses the updated choke opening and the updated torque derating to predict flowrate Q, WC, GOR, and PL, according to some embodiments. In some embodiments, the calibration ROM 902 and the inverse ROM 904 can be instantiated at a particular operating point of the ESP well, and brought online to function as a digital twin of the ESP well using real-time data. The calibration ROM 902 and the inverse ROM 904 can be created or generated using the techniques described in greater detail above (e.g., by the twinning tool 701 as described in greater detail with reference to FIG. 7), according to some embodiments.

Referring now to FIG. 10, a graph 1000 shows a difference between an estimated flow and a measured flow of the ROMs shown in diagram 900, according to some embodiments. Graph 1000 shows the difference between measured flow and estimated flow over time, according to some embodiments. If an error between the measured flow and the estimated flow exceeds a corresponding threshold value, the calibration ROM 902 and the inverse ROM 904 can be re-trained or calibrated to minimize overall error, according to some embodiments.

Referring now to FIG. 11, a graph 1100 shows a difference between an estimated WC and a measured WC of the ROMs shown in diagram 900, according to some embodiments. Graph 1100 shows the difference between the estimated WC and the measured WC over time, according to some embodiments. If an error between the measured WC and the estimated WC exceeds a corresponding threshold value, the calibration ROM 902 and the inverse ROM 904 can be re-trained or calibrated to minimize overall error, according to some embodiments.

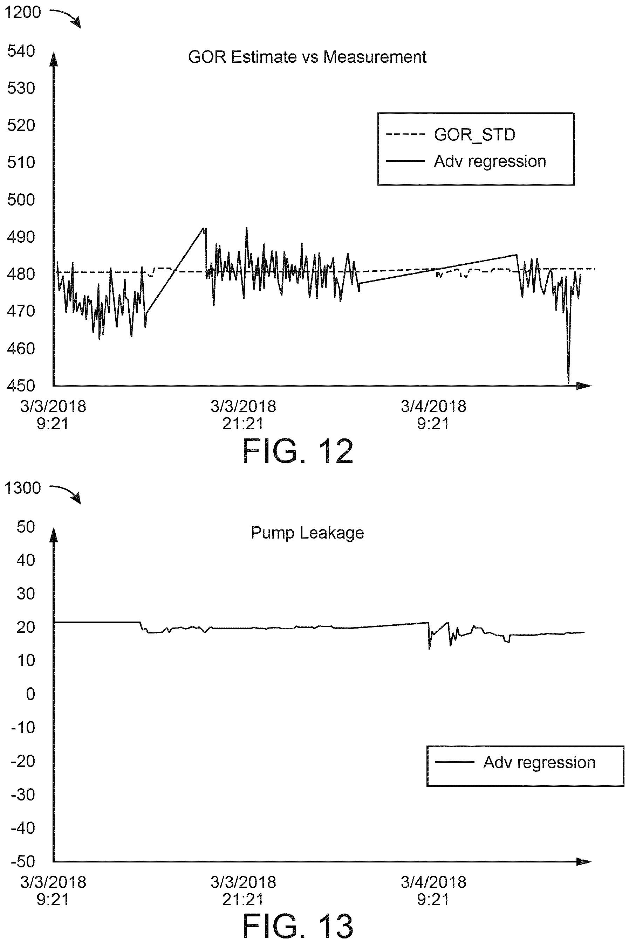

Referring now to FIG. 12, a graph 1200 shows a difference between an estimated GOR and a measured GOR of the ROMs shown in diagram 900, according to some embodiments. Graph 1200 shows the difference between the estimated GOR and the measured GOR over time, according to some embodiments. If an error between the measured GOR and the estimated GOR exceeds a corresponding threshold value, the calibration ROM 902 and the inverse ROM 904 can be re-trained or calibrated to minimize overall error, according to some embodiments.

Referring now to FIG. 13, a graph 1300 shows estimated PL over time, according to some embodiments. In some embodiments, PL may be difficult to measure so a comparison between estimated and measured PL cannot be obtained. However, if error between the estimated flow and the measured flow, the estimated WC and the measured WC, and the estimated GOR and the measured GOR is minimal, the estimated PL can be confidently assumed to be accurate.

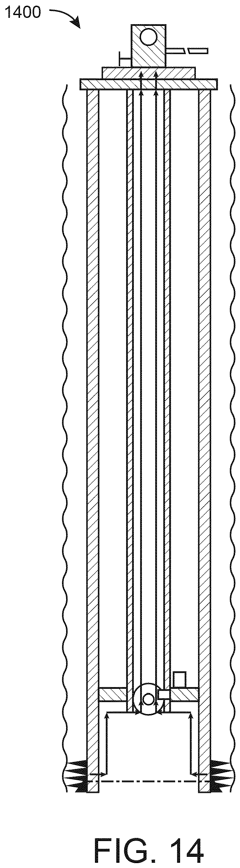

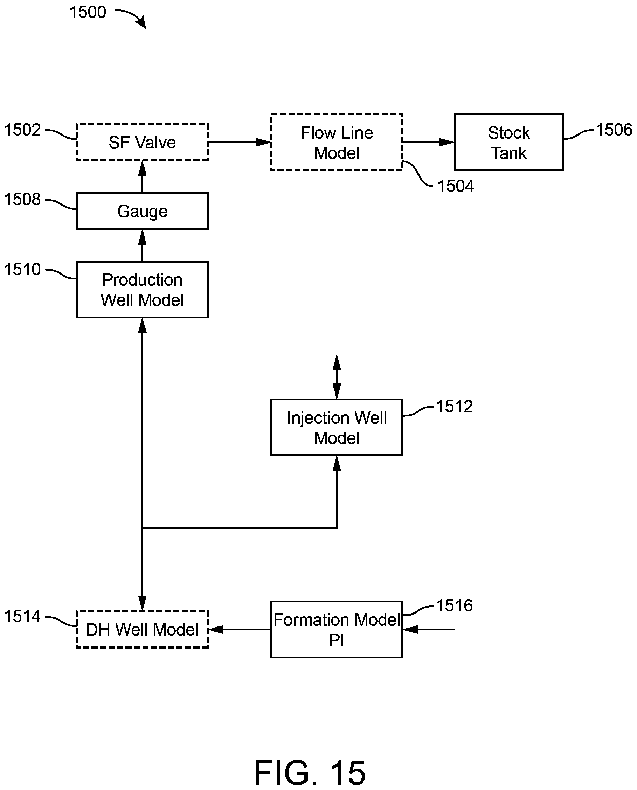

Referring now to FIGS. 14-15, a diagram 1500 for a gas lift well 1400 shows different simulation models or simulators that can be used to generate a forward ROM for the gas lift well 1400, according to some embodiments. The models can include a dry hole (DH) well model 1514, a formation model 1516, an injection well model 1512, a production well model 1510, a gauge model 1508, a sulfur (SF) valve model 1502, a flow line model 1504, and a stock tank model 1506, according to some embodiments. In some embodiments, the different models described herein are configured to use variables or parameters such as formation pressure, GOR, WC, PI, fluid flow rate, gas flow rate, downhole pressure, injection pressure, injection rate, wellhead pressure, flow line pressure, etc. In some embodiments, one or more of the variables or parameters described herein are variables that are always measureable. In some embodiments, one or more of the variables or parameters described herein are unmeasurable values. In some embodiments, one or more of the variables or parameters described herein are values that can be obtained from a well test or outputs of a calibration ROM, or otherwise obtained by calibration. A forward ROM for the diagram 1500 can be generated using the systems and methods described herein (e.g., by the twinning tool 702 as described in greater detail above with reference to FIG. 7), according to some embodiments.

## Example Dashboard

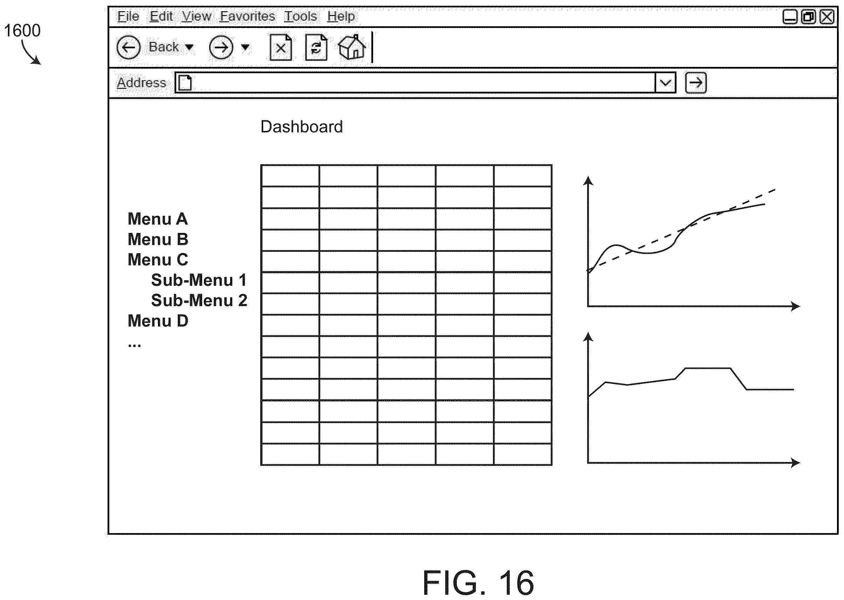

Referring now to FIG. 16, a dashboard 1600 is shown that can be presented on a webpage, according to some embodiments. The dashboard 1600 may be one of the dashboards 726 that are based on outputs of a digital twin (e.g., the digital twin 718) or a digital twin itself, according to some embodiments. In some embodiments, the dashboard 1600 includes one or more graphs or tables of time-series data such as different outputs, predicted values, estimated values, system values, etc., of a system that a digital twin represents. For example, the graphs may include gas lift performance graphs, nodal analysis graphs, pressure to temperature ratio graphs, temperature graphs, liquid rate graphs, etc. The dashboard 1600 may be generated and provided to a technician for further analysis and control, according to some embodiments. The dashboard 1600 can also include different menus or sub-menus for navigation, according to some embodiments.

## Advantages

Advantageously, the systems and methods described herein can be used to provide a reliable digital twin of a real-world system. Using a digital twin that is an instantiation of one or more ROMs can improve a calculation speed, as opposed to using simulations, which may be computationally heavy. The digital twin can be implemented in an online mode to use real-time measurements from the real-world system (e.g., a hydrocarbon well pump) for real-time control, analysis, optimization, etc. The digital twin can be calibrated periodically to ensure that the digital twin accurately represents the real-world system.

## Calibration ROMs with Optimization

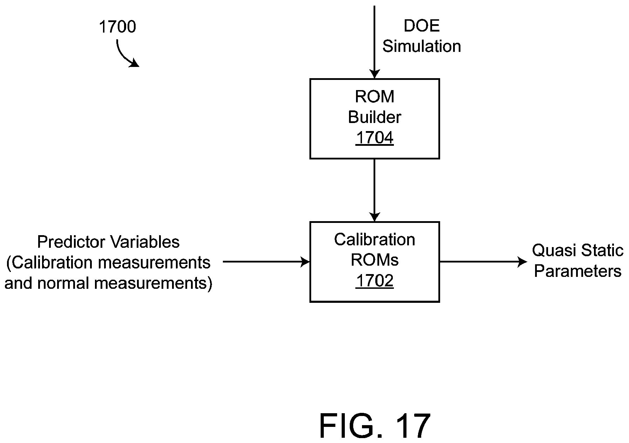

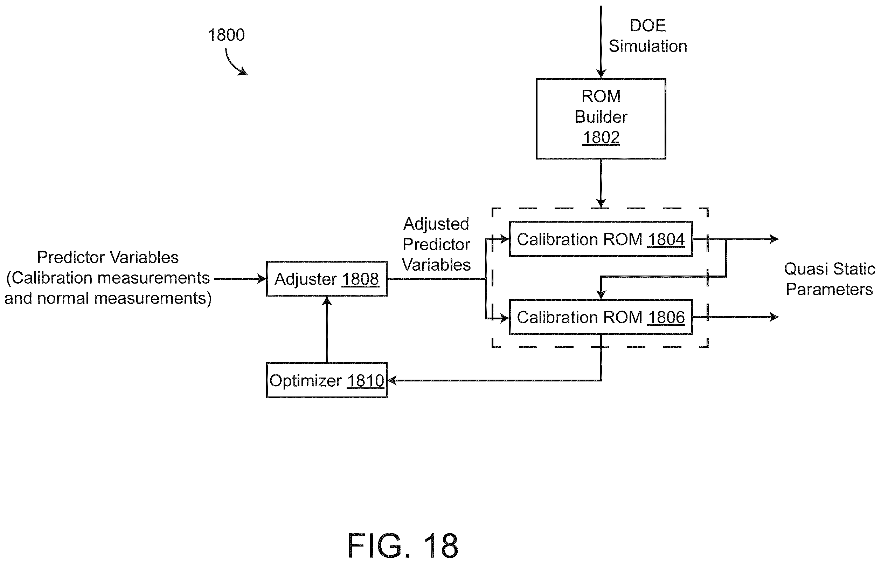

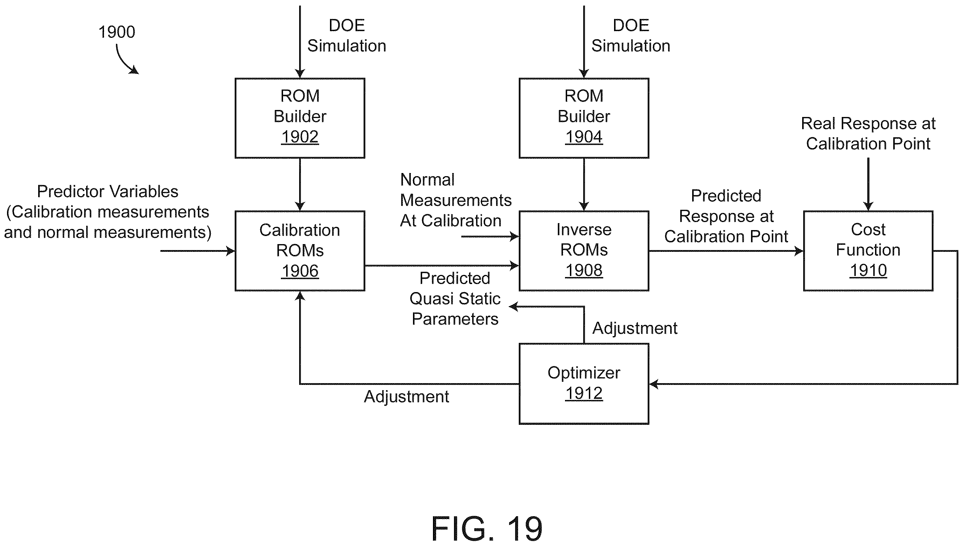

Referring to FIGS. 17-19, various implementations of a calibration ROM are shown illustrated as block diagrams, according to some embodiments. Specifically, FIG. 17 shows a general workflow of a calibration ROM (e.g., calibration ROM 500, the calibration ROM 902, etc.), FIG. 18 shows a first optimization implementation with calibration ROMs, and FIG. 19 shows a second optimization implementation with calibration ROMs. Any of the block diagrams, techniques, systems, etc., described herein with reference to FIGS. _-_ may be implemented by the twinning tool 702 (e.g., the processing circuitry 704 thereof), remote processing circuitry, distributed processing circuitry, one or more servers, a local controller, a cloud computing system, etc., or any combination thereof.

Referring to FIG. 17, a diagram 1700 illustrates the implementation of a calibration ROM 1702, according to some embodiments. In some embodiments, the calibration ROM 1702 is generated by a ROM builder 1704 that uses a curve-fitting technique to determine parameters of the calibration ROM 1702 (e.g., to instantiate the calibration ROM 1702 based on simulation data, shown as DOE simulation data). In some embodiments, the calibration ROM 1702 is generated using any of the techniques described in greater detail above with reference to FIGS. 1-16 (e.g., by the twinning tool 702). For example, the DOE simulation data may be outputs of the simulators 710 and/or the DOE manager 712, and the ROM builder 1704 may be the ROM generator 714.

Once built, generated, instantiated, etc., by the ROM builder 1704, the calibration ROM 1702 can be configured to predict, output, estimate, calculate, etc., one or more quasi-static parameters given inputs of predictor variables. The predictor variables can include any calibration measurements or normal measurements provided by a system (e.g., by the system 728, by sensors of the ESP well 826, etc.). For example, the predictor variables may be measurements of various parameters of the system that is being twinned (e.g., the system 728). In some embodiments, if the system is an ESP, the predictor variables may include GOR.

The quasi-static parameters can be parameters that are used by an inverse ROM to predict one or more of the predictor variables (e.g., a predicted version of the predictor variables, where the predictor variables are measurements). The quasi-static parameters, for example, may be a separator efficiency in the case of an ESP so that one or more inverse ROMs may use the quasi-static parameters to predict values of the GOR (e.g., one of the predictor variables).

Referring to FIG. 18, a diagram 1800 of a first optimization implementation is shown, according to some embodiments. The diagram 1800 includes a ROM builder 1802 that is configured to generate one or more calibration ROMs, shown as calibration ROM 1804, and calibration ROM 1806, an optimizer 1810, and an adjuster 1808. The system of the first optimization shown in diagram 1800 can be implemented on any processing circuitry of the digital twin (e.g., the twinning tool 702, remote processing circuitry, etc.). The first optimization implementation shown in diagram 1800 can be implemented in order to determine a factor or a derating factor that achieves convergence or stability with other factors (e.g., derating factors) for quasi-static parameters of the digital twin. For example, the calibration ROM 1804 may be a calibration ROM for a first quasi-static parameter that outputs a factor of the first quasi-static parameter to an inverse ROM and to the calibration ROM 1806. Similarly, the calibration ROM 1806 may be for a second quasi-static parameter, and output the calculated second quasi-static parameter or factor of the second quasi-static parameter to the optimizer 1810 and/or to the inverse ROM. In some embodiments, more than two calibration ROMs 1804-1806 are used in series, with each calibration ROM associated with a corresponding quasi-static parameter, and outputting the corresponding quasi-static parameter to another of the calibration ROMs. Each of the multiple calibration ROMs can also be provided a specific unknown quasi-static parameter as an input.

As shown in FIG. 18, the optimizer 1810 can monitor the received quasi-static parameters from the calibration ROMs 1804 and 1806 to determine if the quasi-static parameters are varying or if the quasi-static parameters have converged (e.g., are stable). If the quasi-static parameters have not converged, the optimizer 1810 may notify the adjuster 1808, and the adjuster may adjust or change one of the quasi-static parameters (e.g., the unknown quasi-static parameter) and provide the adjusted or changed quasi-static parameter to the calibration ROMs 1804 and 1806. The optimizer 1810 and the adjuster 1808 can continue checking the quasi-static parameters and adjusting at least one of the quasi-static parameters until the optimizer 1810 identifies that the quasi-static parameters have converged or are no longer varying. This may indicate that a value of the unknown quasi-static parameter has been found that results in an internally stable or converged ROM or digital twin. The quasi-static parameters, including the value or factor of the unknown quasi-static parameter may be provided to an inverse ROM as inputs.

Advantageously, the first optimization implementation shown in diagram 1800 of FIG. 18 can be used for under-defined or underdetermined problems (e.g., problems where one or more of the quasi-static parameters are unknown). The quasi-static parameters can be adjusted, tuned, changed, etc., and monitored to observe their convergence until convergence or stability is met.

Referring to FIG. 19, a diagram 1900 of a second optimization implementation is shown, according to some embodiments. The diagram 1900 includes a ROM builder 1902 for calibration ROMs, calibration ROMs 1906, a ROM builder 1904 for inverse ROMs, inverse ROMs 1908, a cost function 1910, and an optimizer 1912. The ROM builder 1902 is configured to calculate, determine, instantiate, etc., the calibration ROMs 1906, and the ROM builder 1904 is configured to calculate, determine, instantiate, etc., the inverse ROMs 1908, according to some embodiments. In some embodiments, the ROM builder 1902 and the ROM builder 1904 are configured to implement any of the functionality or techniques of the ROM generator 714 to generate the inverse ROMs 1908 and the calibration ROMs 1906. The ROM builder 1902 and the ROM builder 1904 can be configured to perform a curve-fitting technique to generate the calibration ROMs 1906 and the inverse ROMs 1908. In some embodiments, the techniques described herein with reference to FIG. 19 are part of an automatic calibration check. The second optimization implementation can be performed to check consistency between the calibration ROMs (e.g., inputs of the calibration ROMs) and outputs of the inverse ROMs.

The calibration ROMs 1906 receive various values of calibration measurements, shown as predictor variables, and output predicted quasi-static parameters, according to some embodiments. The predicted quasi-static parameters are provided, in combination with normal measurements as inputs to the inverse ROMs 1908, according to some embodiments.

The calibration ROMs 1906 are configured to output predicted quasi-static parameters to the inverse ROMs 1908 based on the predictor variables (e.g., measurements of the predictor variables and other normal measurements), according to some embodiments. The inverse ROMs 1908 receive the predicted quasi-static parameters from the calibration ROMs 1906, and one or more normal measurements of calibration points of the system, according to some embodiments. In some embodiments, the inverse ROMs 1908 are configured to use the predicted quasi-static parameters and the normal measurements to output a predicted response (e.g., a predicted flow rate). The cost function 1910 obtains both the response predicted by the inverse ROMs 1908 for the predicted quasi-static parameters and the normal measurements, and the actual response as measured, according to some embodiments. In some embodiments, the predicted response is a response that is predicted to occur in the system given the current measured conditions (the normal measurements) and the predicted quasi-static parameters that define the behavior of the system. Since the current conditions are measured conditions, and the predicted response can be compared to the actual response, any differences or discrepancies between the predicted response of the system and the real response of the system may indicate that adjustments should be made to the quasi-static parameters in order to more accurately define the behavior of the system.

The cost function 1910 compares the predicted response and the real response of the system and quantifies an error (e.g., a prediction error) between the predicted response and the real response, according to some embodiments. The optimizer 1912 uses the error provided by the cost function 1910 and adjusts the calibration ROMs 1906, the predicted quasi-static parameters, or both, to drive the error towards zero (e.g., minimizing the cost function 1910).

The cost function 1910 may determine error between a predicted response and an actual response for a single variable or parameter, or for multiple variables or parameters. If the cost function 1910 models multiple variables or parameters (e.g., flow rate, GOR, etc.), then each of the prediction errors associated with the multiple variables or parameters can be assigned a weighting value so that the cost function 1910 outputs an overall or weighted prediction error which the optimizer 1912 may minimize (by adjusting the predicted quasi-static parameters or by tuning the calibration ROMs 1906). In some embodiments, the optimization problem solved by the optimizer 1912 includes constraints on variability of the quasi-static parameters so that the optimizer 1912 minimizes the prediction error (e.g., the output of the cost function 1910) by adjusting the calibration ROMs 1906 and/or the predicted quasi-static parameters. The functionality and techniques described herein with reference to FIGS. 18 or 19 can be performed at a specific operating point (e.g., a calibration point) of the system, or at multiple operating points (e.g., multiple calibration points) of the system, according to some embodiments.

**Transient ROMs**

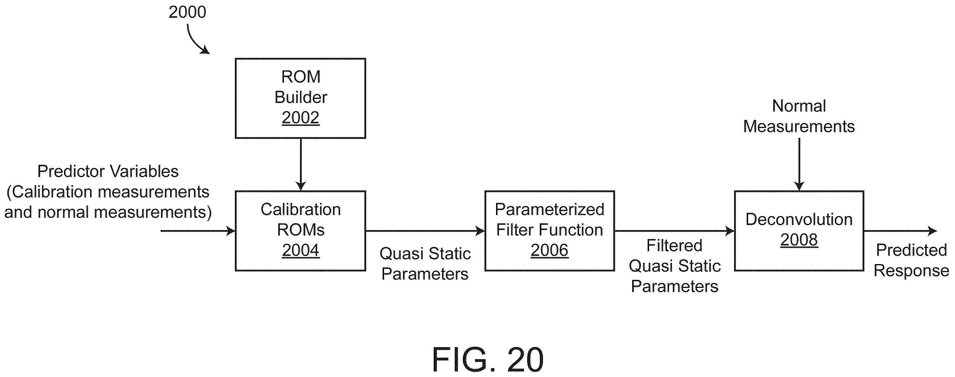

Referring to FIG. 20, a diagram 2000 of a workflow for a transient ROM ("tROM") is shown, according to some embodiments. The diagram 2000 includes a ROM builder 2002, calibration ROMs 2004, a parameterized filter function 2006, and deconvolution 2008. In some embodiments, the ROM builder 2002 is the same as or similar to any of the ROM builders 1904, 1902, 1802, 1704, the ROM generator 714, etc. tROMs, as opposed to using curve-fitting techniques, use convolution and deconvolution since tROMs predict a time curve as a function of another time curve (e.g., a transient response given temporally changing inputs), according to some embodiments.

In some embodiments, the calibration ROMs are configured to receive measurements of the predictor variables and output quasi-static parameters. The quasi-static parameters are used as parameters in a filter, shown as parameterized filter function 2006, according to some embodiments. In some embodiments, the parameterized filter function 2006 is an analytical parameterized model, and the quasi-static parameters are parameters of the model. In some embodiments, the model or the parameterized filter function 2006 is configured to predict or calculate dependencies between dynamic behaviors. In some embodiments, outputs of the parameterized filter function 2006 are deconvoluted at deconvolution 2008 to determine a predicted response of the system. In some embodiments, the parameterized filter function 2006 and the deconvolution 2008 define a tROM 2010.

**Data Synchronization**

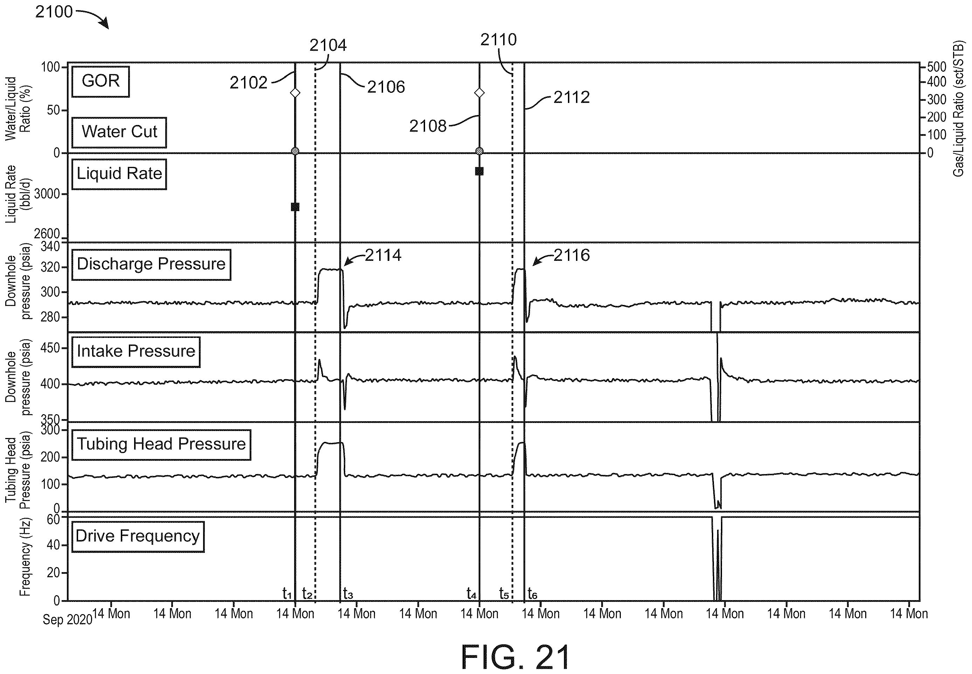

Referring to FIG. 21, a graph 2100 illustrating collected data over time of a system (e.g., an ESP) includes a series of GOR points, a series of WC points, a series of liquid rate points, a series of discharge pressure, a series of intake pressure, a series of tubing head pressure, and a series of drive frequency. The graph 2100 illustrates the performance of a well test and recordation of a data point of GOR, a data point of WC, and a data point of liquid rate, according to some embodiments. As shown in the graph 2100, a first well test 2114 is performed between times $t_2$ and $t_3$ (represented by lines 2104 and 2106) while the data for the first well test (i.e., values of the GOR, the WC, and the liquid rate) are recorded as being obtained at time $t_1$ (represented by line 2102). Similarly, a second well test 2116 is performed between times $t_5$ and $t_6$ (represented by lines 2110 and 2112) while the data for the second well test (i.e., values of the GOR, the WC, and the liquid rate) are recorded as being obtained at time $t_4$ (represented by line 2108). Accordingly, it can be seen in FIG. 21 that the timestamp of the data for the well tests (e.g., calibration data) is out of sync with the actual time at which the well test is performed. This may be due to obtaining the GOR, WC, and liquid rate data from different sources as the discharge pressure, the intake pressure, etc. However, using data in a digital twin that is out of sync with other data may result in discrepancies in outputs of the digital twin. In some embodiments, the calibration data of the well test (e.g., the GOR, the WC, and the liquid rate) are average values collected over the duration of the well test. Accordingly, to synchronize the calibration data of the well test from one source with other data of the well test from a second source may require synchronizing time periods (e.g., synchronizing both start and end times associated with the calibration data and the other data). In some embodiments, the GOR, the WC, and the liquid rate are the independent test results as shown in FIG. 7.

In some embodiments, the synchronization is performed manually by a technician. For example, the data collected may be the real-time inputs (e.g., sensor data obtained from the system 728) or reported data from a technician performing the well test. In some embodiments, the technician can synchronize the data to account for errors in the calibration or well-test data relative to when the well test was performed, different time zones between the different sources of data, etc. In some embodiments, the synchronization is performed automatically by the digital twin 718 or the digital twin generator 716. For example, the digital twin generator 716 may obtain data from different sources (e.g., the real-time inputs, or historical data from the system 728, and the independent test results provided by a technician) and identify a same data point between the two sources (e.g., an identical value of a specific set of data). The digital twin generator 716 may synchronize the timestamps of the data from either source so that the timestamp of the same data point match, and also adjust the rest of the data in the sources, thereby synchronizing the data from the two sources. In some embodiments, the graph 2100 is displayed to a user (e.g., via a display screen, on the dashboard 1600) so that the user can observe the responses of the various obtained data and synchronize the calibration data with the other data sources.

## Weighted Calibration Data

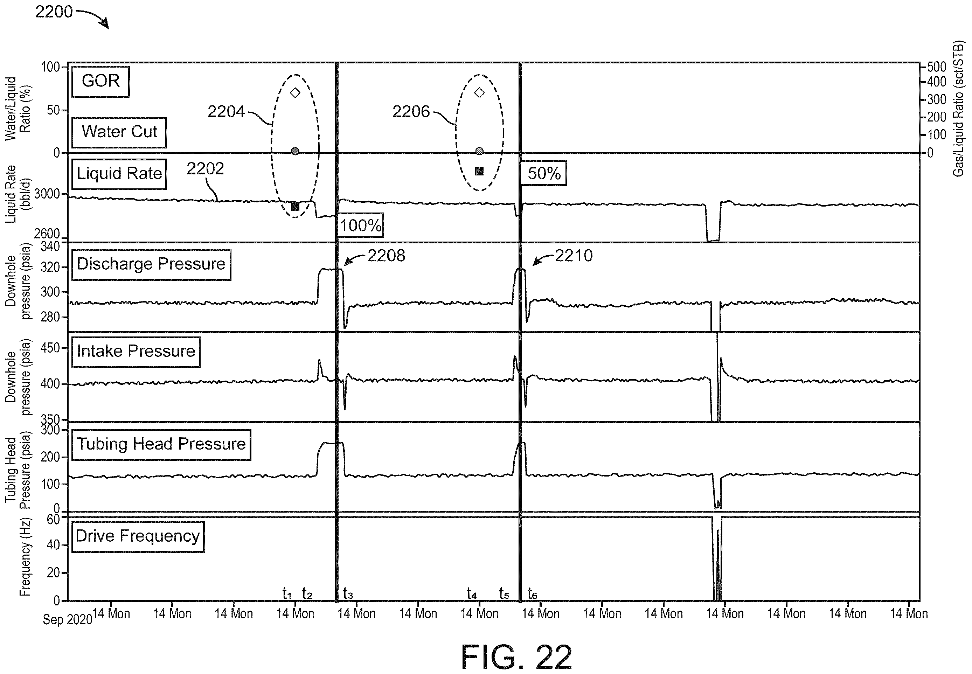

Referring to FIG. 22, a graph 2200 illustrates obtained data from an ESP (e.g., discharge pressure, intake pressure, tubing head pressure, and drive frequency), predicted liquid rate (illustrated by series 2202), and well test or calibration data sets 2204 and 2206 (including GOR, WC, and liquid rate), according to some embodiments. The graph 2200 illustrates a first well test 2208 and a second well test 2210, according to some embodiments. In some embodiments, the predicted liquid rate is an output of a digital twin that is generated using the calibration data sets 2204 and 2206. In some embodiments, a weighting of the calibration sets 2204 or 2206, or a weighting of the output of the digital twin (e.g., the liquid rate) is assigned a weighting based on an expected accuracy of the well tests 2208 or 2210. In some embodiments, the weightings are user assigned values. In some embodiments, the weightings range from 0% to 100%. For example, the well test 2210 is shown having a shorter duration than the duration of the well test 2208, and accordingly may provide less trustworthy data. Accordingly, the user may provide a weighting of 50% to the calibration data set 2206 and a weighting of 100% to the calibration data set 2204 for generation of the digital twin. The weightings may be used to determine a weighted average of the values of the calibration data sets 2204 and 2206 (which can be used in any of the techniques described in greater detail above with reference to any of the calibration ROMs). In some embodiments, the time synchronization techniques describe in detail above with reference to FIG. 21 and the weighting techniques described with reference to FIG. 22 are performed in the context of the digital twin in a closed loop fashion. In some embodiments, the graph 2200 and/or the graph 2100 is/are presented to the user on the dashboard 1600 so that the user can provide (e.g., to the digital twin generator 716) different weightings to the calibration data sets 2204 and 2206, adjust time synchronization, etc., and view the resulting effect of the adjustments to the weighting and the time synchronization on the digital twin output.

## Quasi-static Parameter Thresholds

Referring to FIG. 23, a graph 2300 illustrates the tracking of values of various quasi-static parameters of a digital twin (e.g., the quasi-static parameters of the digital twin 718) over time, according to some embodiments. In some embodiments, the graph 2300 illustrates tracking values of a first quasi-static parameter, a second quasi-static parameter, and a third quasi-static parameter over time. In some embodiments, the twinning tool 702 or the digital twin 718 is configured to compare the values of the quasi-static parameters over time (e.g., series 2302, 2304, or 2306) to corresponding thresholds (e.g., thresholds 2308, 2310, and 2312). In some embodiments, the thresholds 2308, 2310, or 2312 are based on averages of a last n number of values of the quasi-static parameters. If the values of the quasi-static parameters deviate outside of the thresholds 2308, 2310, or 2312, this may indicate that an improper calibration test (e.g., a well test) has been performed, and an alarm may be provided to a user (e.g., by the twining tool 702, the dashboard 726, etc.). In some embodiments, the thresholds 2308, 2310, or 2312 allow the quasi-static parameters to deviate by a certain percentage of the previous value or an average of a previous number of values of the quasi-static parameter. For example, if the previous value of the second quasi-static parameter is 0.55, then the thresholds may be 0.55 +/- 0.05(0.55).

**Alternative Calibration ROM**

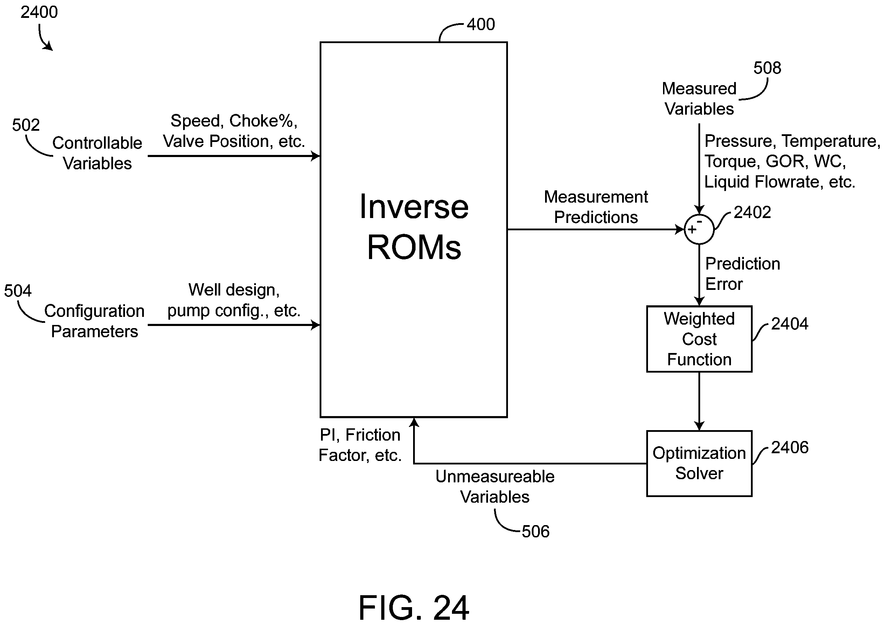

Referring to FIG. 24, a diagram 2400 illustrates an alternative to any of the calibration ROMs as described herein, according to some embodiments. It should be understood that the system illustrated in the diagram 2400 and described herein with reference to FIG. 24 may be used in place of any of the calibration ROMs as described throughout this document.

The calibration ROM may be implemented as an optimization system as shown in FIG. 24, according to some embodiments. Specifically, the inverse ROMs 400 may receive the controllable variables 502 and the configuration parameters 504, and output one or more measurement predictions (e.g., predicted values of measurable variables). The measurement predictions can be predictions of pressure, temperature, torque, GOR, WC, flowrate, etc., or any other variables or parameters that can be measured, according to some embodiments. In some embodiments, the measurement predictions and the measured variables 508 are used (e.g., at junction 2402) to calculate a prediction error (e.g., a difference between the measurement predictions and the measured variables 508). The prediction error can be used in a weighted cost function 2404 which is provided to an optimization solver 2406. The optimization solver 2406 can output, adjust, predict, etc., unmeasurable variables 506 for the inverse ROM 400, according to some embodiments. In this way, the optimization solver 2406 can vary or adjust the values of the unmeasurable variables 506 to drive the weighted cost function 2404 or prediction error towards zero. The unmeasurable variables 506 provided to and used by the inverse ROMs 400 for the determination of the measurement predictions may be a type of tuning parameter or internal parameter that are used by the inverse ROMs 400. Accordingly, determining optimal values of the unmeasurable variables 506 for the inverse ROMs 400 provides an aposteriori optimization that can be performed in place of a calibration ROM.

**Configuration of Exemplary Embodiments**

As utilized herein, the terms "approximately", "about", "substantially", and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed are considered to be within the scope of the invention as recited in the appended claims.

It should be noted that the term "exemplary" as used herein to describe various embodiments is intended to indicate that such embodiments are possible examples, representations, and/or illustrations of possible embodiments (and such term is not intended to connote that such embodiments are necessarily extraordinary or superlative examples).

The terms "coupled," "connected," and the like, as used herein, mean the joining of two members directly or indirectly to one another. Such joining may be stationary (e.g., permanent) or moveable (e.g., removable, releasable, etc.). Such joining may be achieved with the two members or the two members and any additional intermediate members being integrally formed as a single unitary body with one another or with the two members or the two members and any additional intermediate members being attached to one another.

References herein to the positions of elements (e.g., "top," "bottom," "above," "below," etc.) are merely used to describe the orientation of various elements in the figures. It should be noted that the orientation of various elements may differ according to other exemplary embodiments, and that such variations are intended to be encompassed by the present disclosure.

Also, the term "or" is used in its inclusive sense (and not in its exclusive sense) so that when used, for example, to connect a list of elements, the term "or" means one, some, or all of the elements in the list. Conjunctive language such as the phrase "at least one of X, Y, and Z," unless specifically stated otherwise, is otherwise understood with the context as used in general to convey that an item, term, etc. may be either X, Y, Z, X and Y, X and Z, Y and Z, or X, Y, and Z (i.e., any combination of X, Y, and Z). Thus, such conjunctive language is not generally intended to imply that certain embodiments require at least one of X, at least one of Y, and at least one of Z to each be present, unless otherwise indicated.

It is important to note that the construction and arrangement of the elements of the systems and methods as shown in the exemplary embodiments are illustrative only. Although only a few embodiments of the present disclosure have been described in detail, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter recited. For example, elements shown as integrally formed may be constructed of multiple parts or elements. It should be noted that the elements and/or assemblies of the components described herein may be constructed from any of a wide variety of materials that provide sufficient strength or durability, in any of a wide variety of colors, textures, and combinations. Other substitutions, modifications, changes, and omissions may be made in the design, operating conditions, and arrangement of the preferred and other exemplary embodiments without departing from scope of the present disclosure

**Claims**

1.  A method for generating and using a digital twin of a hydrocarbon system, the method **characterized by**:

    performing a plurality of simulations using design of experiments, DOE, techniques to create a hyperdimensional space mapping simulation inputs, outputs and attributes;
    using the hyperdimensional space from the plurality of simulations to generate one or more reduced order models, ROMs, using a regression technique or a machine learning technique;
    generating a digital twin of the hydrocarbon system based on data from an on-site test at the hydrocarbon system by instantiating the one or more ROMs at an operational point of the hydrocarbon system, and configuring the digital twin to use real-time data obtained from the hydrocarbon system;
    estimating values of one or more variables of the hydrocarbon system in real-time using the digital twin; and
    controlling the hydrocarbon system based on the estimated values of the one or more variables.

2.  The method of Claim 1, further **characterized in that** the one or more ROMs comprise:

    a forward ROM;
    an inverse ROM; or
    a calibration ROM.

3.  The method of Claim 2, further **characterized in that** the forward ROM is configured to predict values of one or more variables of the system for a hypothetical scenario based on values of one or more controllable variables, values of one or more configuration parameters, and values of one or more calibration variables.

4.  The method of Claim 2 or 3, further **characterized in that** the inverse ROM is configured to solve an inversion problem to estimate values of one or more system variables of the hydrocarbon system based on values of one or more controllable variables, values of one or more configuration parameters, values of one or more calibration variables, and values of one or more measured variables of the hydrocarbon system.

5.  The method of Claim 2, 3, or 4 further **characterized in that** the calibration ROM is configured to estimate one or more calibration variables for the forward ROM and the inverse ROM based on values of one or more controllable variables, values of one or more configuration parameters, values of one or more unmeasurable variables, and values of one or more measured variables.

6.  The method of Claim 1, 2, 3, or 4, further **characterized in that** the digital twin comprises an instantiation of a plurality of ROMs, wherein one or more of the plurality of ROMs are configured to provide an output to a different ROM of the plurality of ROMs as an input.

7.  The method of Claim 1, 2, 3, or 4, further **characterized by**:

    performing the on-site test at the hydrocarbon system to obtain calibration data; and
    at least one of:

        re-generating the one or more ROMs and re-generating the digital twin using the calibration data to generate a calibrated digital twin; or
        providing the calibration data to a calibration ROM for use in updating one or more other ROMs of the digital twin.

8.  The method of Claim 7, further **characterized in that** the re-generation comprises an automated selection of an optimal combination of both a DOE sampling scheme, and ROM model and parameters, simultaneously in the presence of calibration measurements and a calibration match criteria.

9.  The method of Claim 8, further **characterized in that** the re-generation comprises an iterative process and a Bayesian regularization technique.

10. A system for generating and using a digital twin of a hydrocarbon system, the system **characterized by**:
a processor configured carry out the method steps of claim 1.

11. The system of Claim 10, further **characterized in that** the real-time data comprises at least one of a wellhead pressure, a flow line pressure, an injection pressure, an injection rate, a pump discharge pressure, a pump intake pressure, a voltage, a current, or a motor temperature of the hydrocarbon system.

12. The system of Claim 10 or 11, further **characterized in that** the processor is configured to perform an automatic calibration check of the digital twin, wherein performing the automatic calibration check comprises:

obtaining measurements of one or more predictor variables of the hydrocarbon system;
determining one or more quasi-static parameters using the measurements of the one or more predictor variables;
determining if the one or more quasi-static parameters have converged;
in response to determining that the one or more quasi-static parameters have not converged, adjusting one or more of the predictor variables and re-determining the one or more quasi-static parameters and re-determining if the one or more quasi-static parameters have converged.

13. The system of Claim 10, 11 or 12, further **characterized in that** the processor is configured to perform an automatic calibration check of the digital twin, wherein performing the automatic calibration check comprises:

obtaining measurements of one or more predictor variables of the hydrocarbon system;
determining one or more quasi-static parameters using the measurements of the one or more predictor variables;
determining a predicted response using the one or more quasi-static parameters;
comparing the predicted response to an actual response of the hydrocarbon system to determine a prediction error of the response; and
minimizing the prediction error by adjusting the quasi-static parameters and re-determining the predicted response, and re-comparing the predicted response to the actual response to determine the prediction error of the response.

14. The system of Claim 10, 11, 12 or 13, further **characterized in that** the transient ROM comprises a filter function, the parameters of the filter function being one or more quasi-static parameters output by a calibration ROM, wherein the filter function is configured to use deconvolution and the filter function to determine a predicted response given an input of one or more measurements of the hydrocarbon system.

**Patentansprüche**

1. Verfahren zum Erzeugen und Verwenden eines digitalen Zwillings eines Kohlenwasserstoffsystems, wobei das Verfahren **gekennzeichnet ist durch**:

Durchführen einer Vielzahl von Simulationen unter Verwendung von Techniken der Versuchsplanung, DOE (Design of Experiments), zum Erstellen eines hyperdimensionalen Raums, der Simulationseingaben, -ausgaben und -attribute abbildet;
Verwenden des hyperdimensionalen Raums aus der Vielzahl von Simulationen zum Erzeugen eines oder mehrerer reduzierter Ordnungsmodelle, ROMs, unter Verwendung einer Regressionstechnik oder einer Technik maschinellen Lernens;
Erzeugen eines digitalen Zwillings des Kohlenwasserstoffsystems auf der Grundlage von Daten aus einem Vor-Ort-Test am Kohlenwasserstoffsystem **durch** Instanziieren des einen oder der mehreren ROMs an einem Betriebspunkt des Kohlenwasserstoffsystems, und Konfigurieren des digitalen Zwillings zur Verwendung von Echtzeitdaten, die vom Kohlenwasserstoffsystem erhalten wurden;
Schätzen von Werten einer oder mehrerer Variablen des Kohlenwasserstoffsystems in Echtzeit unter Verwendung des digitalen Zwillings; und
Steuern des Kohlenwasserstoffsystems auf der Grundlage der geschätzten Werte der einen oder mehreren Variablen.

2. Verfahren nach Anspruch 1, weiter **dadurch gekennzeichnet, dass** das eine oder die mehreren ROMs Folgendes umfassen:

ein Vorwärts-ROM;
ein inverses ROM; oder
ein Kalibrierungs-ROM.

**3.** Verfahren nach Anspruch 2, weiter **dadurch gekennzeichnet, dass** das Vorwärts-ROM so konfiguriert ist, dass es Werte einer oder mehrerer Variablen des Systems für ein hypothetisches Szenario auf der Grundlage von Werten einer oder mehrerer steuerbarer Variablen, Werten eines oder mehrerer Konfigurationsparameter und Werten einer oder mehrerer Kalibrierungsvariablen vorhersagt.

**4.** Verfahren nach Anspruch 2 oder 3, weiter **dadurch gekennzeichnet, dass** das inverse ROM so konfiguriert ist, dass es ein Inversionsproblem löst, um Werte einer oder mehrerer Systemvariablen des Kohlenwasserstoffsystems auf der Grundlage von Werten einer oder mehrerer steuerbarer Variablen, Werten eines oder mehrerer Konfigurationsparameter, Werten einer oder mehrerer Kalibrierungsvariablen und Werten einer oder mehrerer gemessener Variablen des Kohlenwasserstoffsystems zu schätzen.

**5.** Verfahren nach Anspruch 2, 3 oder 4, weiter **dadurch gekennzeichnet, dass** das Kalibrierungs-ROM so konfiguriert ist, dass es eine oder mehrere Kalibrierungsvariablen für das Vorwärts-ROM und das inverse ROM auf der Grundlage von Werten einer oder mehrerer steuerbarer Variablen, Werten eines oder mehrerer Konfigurationsparameter, Werten einer oder mehrerer nicht messbarer Variablen und Werten einer oder mehrerer gemessener Variablen schätzt.

**6.** Verfahren nach Anspruch 1, 2, 3 oder 4, weiter **dadurch gekennzeichnet, dass** der digitale Zwilling eine Instanziierung einer Vielzahl von ROMs umfasst, wobei ein oder mehrere der Vielzahl von ROMs so konfiguriert sind, dass sie einem anderen ROM der Vielzahl von ROMs eine Ausgabe als Eingabe bereitstellen.

**7.** Verfahren nach Anspruch 1, 2, 3 oder 4, weiter **gekennzeichnet durch**:

Durchführen des Vor-Ort-Tests am Kohlenwasserstoffsystem, um Kalibrierungsdaten zu erhalten; und mindestens eines von:

erneutem Erzeugen des einen oder der mehreren ROMs und erneutem Erzeugen des digitalen Zwillings unter Verwendung der Kalibrierungsdaten, um einen kalibrierten digitalen Zwilling zu erzeugen; oder Bereitstellen der Kalibrierungsdaten für ein Kalibrierungs-ROM zur Verwendung beim Aktualisieren eines oder mehrerer anderer ROMs des digitalen Zwillings.

**8.** Verfahren nach Anspruch 7, weiter **dadurch gekennzeichnet, dass** die erneute Erzeugung eine automatische Auswahl einer optimalen Kombination aus einem DOE-Probenahmeschema und einem ROM-Modell und -Parametern gleichzeitig bei Vorhandensein von Kalibrierungsmessungen und einem Kalibrierungsübereinstimmungskriterium umfasst.

**9.** Verfahren nach Anspruch 8, weiter **dadurch gekennzeichnet, dass** die erneute Erzeugung einen iterativen Prozess und eine Bayes'sche Regularisierungstechnik umfasst.

**10.** System zum Erzeugen und Verwenden eines digitalen Zwillings eines Kohlenwasserstoffsystems, wobei das System **gekennzeichnet ist durch**:
einen Prozessor, der zum Ausführen der Verfahrensschritte von Anspruch 1 konfiguriert ist.

**11.** System nach Anspruch 10, weiter **dadurch gekennzeichnet, dass** die Echtzeitdaten mindestens eines von einem Bohrlochkopfdruck, einem Fließleitungsdruck, einem Injektionsdruck, einer Injektionsrate, einem Pumpenauslassdruck, einem Pumpenansaugdruck, einer Spannung, einem Strom oder einer Motortemperatur des Kohlenwasserstoffsystems umfassen.

**12.** System nach Anspruch 10 oder 11, weiter **dadurch gekennzeichnet, dass** der Prozessor so konfiguriert ist, dass er eine automatische Kalibrierungsprüfung des digitalen Zwillings durchführt, wobei Durchführen der automatischen Kalibrierungsprüfung Folgendes umfasst:

Erhalten von Messungen einer oder mehrerer Prädiktorvariablen des Kohlenwasserstoffsystems;

Bestimmen eines oder mehrerer quasistatischer Parameter unter Verwendung der Messungen der einen oder mehreren Prädiktorvariablen;

Bestimmen, ob der eine oder die mehreren quasistatischen Parameter konvergiert sind;

als Reaktion auf Bestimmen, dass der eine oder die mehreren quasistatischen Parameter nicht konvergiert sind, Anpassen einer oder mehrerer der Prädiktorvariablen und erneutes Bestimmen des einen oder der mehreren quasistatischen Parameter und erneutes Bestimmen, ob der eine oder die mehreren quasistatischen Parameter konvergiert sind.

13. System nach Anspruch 10, 11 oder 12, weiter **dadurch gekennzeichnet, dass** der Prozessor so konfiguriert ist, dass er eine automatische Kalibrierungsprüfung des digitalen Zwillings durchführt, wobei Durchführen der automatischen Kalibrierungsprüfung Folgendes umfasst:

Erhalten von Messungen einer oder mehrerer Prädiktorvariablen des Kohlenwasserstoffsystems;

Bestimmen eines oder mehrerer quasistatischer Parameter unter Verwendung der Messungen der einen oder mehreren Prädiktorvariablen;

Bestimmen einer vorhergesagten Antwort unter Verwendung des einen oder der mehreren quasistatischen Parameter;

Vergleichen der vorhergesagten Antwort mit einer tatsächlichen Antwort des Kohlenwasserstoffsystems, um einen Vorhersagefehler der Antwort zu bestimmen; und

Minimieren des Vorhersagefehlers durch Anpassen der quasistatischen Parameter und erneutes Bestimmen der vorhergesagten Antwort und erneutes Vergleichen der vorhergesagten Antwort mit der tatsächlichen Antwort, um den Vorhersagefehler der Antwort zu bestimmen.

14. System nach Anspruch 10, 11, 12 oder 13, weiter **dadurch gekennzeichnet, dass** das transiente ROM eine Filterfunktion umfasst, wobei die Parameter der Filterfunktion ein oder mehrere quasistatische Parameter sind, die von einem Kalibrierungs-ROM ausgegeben werden, wobei die Filterfunktion so konfiguriert ist, dass sie eine Dekonvolution verwendet, und die Filterfunktion dazu dient, bei einer Eingabe von einer oder mehreren Messungen des Kohlenwasserstoffsystems eine vorhergesagte Antwort zu bestimmen.

## Revendications

1. Procédé de génération et d'utilisation d'un jumeau numérique d'un système d'hydrocarbures, le procédé étant **caractérisé par** :

la réalisation d'une pluralité de simulations en utilisant des techniques de plan d'expériences, DOE, pour créer un espace hyperdimensionnel en mappant les entrées, les sorties et les attributs de simulation ;

l'utilisation de l'espace hyperdimensionnel émanant de la pluralité de simulations pour générer un ou plusieurs modèles d'ordre réduit, ROM, en utilisant une technique de régression ou une technique d'apprentissage automatique ;

la génération d'un jumeau numérique du système d'hydrocarbures sur la base de données provenant d'un test sur site au niveau du système d'hydrocarbures en instanciant les un ou plusieurs ROM en un point opérationnel du système d'hydrocarbures, et la configuration du jumeau numérique pour utiliser des données en temps réel obtenues à partir du système d'hydrocarbures ;

l'estimation de valeurs d'une ou de plusieurs variables du système d'hydrocarbures en temps réel à l'aide du jumeau numérique ; et

la commande du système d'hydrocarbures sur la base des valeurs estimées des une ou plusieurs variables.

2. Procédé selon la revendication 1, en outre **caractérisé en ce que** les un ou plusieurs ROM comprennent :

un ROM avancé ;
un ROM inverse ; ou
un ROM d'étalonnage.

3. Procédé selon la revendication 2, en outre **caractérisé en ce que** le ROM avancé est configuré pour prédire des valeurs d'une ou de plusieurs variables du système pour un scénario hypothétique sur la base de valeurs d'une ou de plusieurs variables commandables, de valeurs d'un ou de plusieurs paramètres de configuration et de valeurs d'une ou de plusieurs variables d'étalonnage.

4. Procédé selon la revendication 2 ou 3, en outre **caractérisé en ce que** le ROM inverse est configuré pour résoudre un problème d'inversion pour estimer des valeurs d'une ou de plusieurs variables système du système d'hydrocarbures sur la base de valeurs d'une ou de plusieurs variables commandables, de valeurs d'un ou de plusieurs paramètres de configuration, de valeurs d'une ou de plusieurs variables d'étalonnage et de valeurs d'une ou de plusieurs variables mesurées du système d'hydrocarbures.

5. Procédé selon la revendication 2, 3 ou 4, en outre **caractérisé en ce que** le ROM d'étalonnage est configuré pour estimer une ou plusieurs variables d'étalonnage pour le ROM avancé et le ROM inverse sur la base de valeurs d'une ou de plusieurs variables commandables, de valeurs d'un ou de plusieurs paramètres de configuration, de valeurs d'une ou de plusieurs variables non mesurables et de valeurs d'une ou de plusieurs variables mesurées.

6. Procédé selon la revendication 1, 2, 3 ou 4, **caractérisé en outre en ce que** le jumeau numérique comprend une instanciation d'une pluralité de ROM, dans lequel un ou plusieurs de la pluralité de ROM sont configurés pour fournir une sortie à un ROM différent de la pluralité de ROM en tant qu'entrée.

7. Procédé selon la revendication 1, 2, 3 ou 4, en outre **caractérisé par** :

   la réalisation du test sur site au niveau du système d'hydrocarbures pour obtenir des données d'étalonnage ; et au moins l'une parmi :

   la régénération des un ou plusieurs ROM et la régénération du jumeau numérique en utilisant les données d'étalonnage pour générer un jumeau numérique étalonné ; ou
   la fourniture des données d'étalonnage à un ROM d'étalonnage pour les utiliser dans la mise à jour d'un ou de plusieurs autres ROM du jumeau numérique.

8. Procédé selon la revendication 7, en outre **caractérisé en ce que** la régénération comprend une sélection automatisée d'une combinaison optimale à la fois d'un schéma d'échantillonnage DOE et d'un modèle ROM et de paramètres, simultanément en présence de mesures d'étalonnage et de critères de correspondance d'étalonnage.

9. Procédé selon la revendication 8, en outre **caractérisé en ce que** la régénération comprend un processus itératif et une technique de régularisation bayésienne.

10. Système de génération et d'utilisation d'un jumeau numérique d'un système d'hydrocarbures, le système étant **caractérisé par** :
    un processeur configuré pour exécuter les étapes de procédé selon la revendication 1.

11. Système selon la revendication 10, en outre **caractérisé en ce que** les données en temps réel comprennent au moins l'une d'une pression de tête de puits, d'une pression de conduite d'écoulement, d'une pression d'injection, d'un débit d'injection, d'une pression de refoulement de pompe, d'une pression d'admission de pompe, d'une tension, d'un courant ou d'une température de moteur du système d'hydrocarbures.

12. Système selon la revendication 10 ou 11, en outre **caractérisé en ce que** le processeur est configuré pour effectuer un contrôle d'étalonnage automatique du jumeau numérique, dans lequel la réalisation du contrôle d'étalonnage automatique comprend :

    l'obtention de mesures d'une ou de plusieurs variables prédictives du système d'hydrocarbures;
    la détermination d'un ou de plusieurs paramètres quasi statiques à l'aide des mesures des une ou plusieurs variables prédictives ;
    la détermination du fait que les un ou plusieurs paramètres quasi statiques ont ou non convergé ;
    en réponse à la détermination que les un ou plusieurs paramètres quasi statiques n'ont pas convergé, l'ajustement d'une ou de plusieurs des variables prédictives et la redétermination des un ou plusieurs paramètres quasi statiques et la redétermination du fait que les un ou plusieurs paramètres quasi statiques ont ou non convergé.

13. Système selon la revendication 10, 11 ou 12, en outre **caractérisé en ce que** le processeur est configuré pour effectuer un contrôle d'étalonnage automatique du jumeau numérique, dans lequel la réalisation du contrôle d'étalonnage automatique comprend :

l'obtention de mesures d'une ou de plusieurs variables prédictives du système d'hydrocarbures;
la détermination d'un ou de plusieurs paramètres quasi statiques à l'aide des mesures des une ou plusieurs variables prédictives ;
la détermination d'une réponse prédite à l'aide des un ou plusieurs paramètres quasi statiques ;
la comparaison de la réponse prédite à une réponse réelle du système d'hydrocarbures pour déterminer une erreur de prédiction de la réponse ; et
la réduction au minimum de l'erreur de prédiction en ajustant les paramètres quasi statiques et en redéterminant la réponse prédite, et la comparaison, à nouveau, de la réponse prédite à la réponse réelle pour déterminer l'erreur de prédiction de la réponse.

14. Système selon la revendication 10, 11, 12 ou 13, en outre **caractérisé en ce que** le ROM transitoire comprend une fonction de filtre, les paramètres de la fonction de filtre étant un ou plusieurs paramètres quasi statiques délivrés en sortie par un ROM d'étalonnage, dans lequel la fonction de filtre est configurée pour utiliser une déconvolution et la fonction de filtre pour déterminer une réponse prédite selon une entrée d'une ou de plusieurs mesures du système d'hydrocarbures.

FIG. 1

200

| | 202 |
| --- | --- |
| Perform multiple simulations in a hyperdimensional space to generate outputs | |

| | 204 |
| --- | --- |
| Use the outputs of the multiple simulations to generate one or more reduced order models (ROMs) using a regression technique or machine learning technique | |

| | 206 |
| --- | --- |
| Generate a digital twin of a system using the one or more ROMs, the digital twin including at least one of the one or more ROMs | |

| | 208 |
| --- | --- |
| Use the digital twin to predict or output values of one or more variables in a real-time application | |

| | 210 |
| --- | --- |
| Perform an independent test on measurable outputs of the system | |

| | 212 |
| --- | --- |
| Perform a calibration based on results of the independent tests | |

| | 214 |
| --- | --- |
| Update one or more parameters of the digital twin or of the ROMs of the digital twin based on the calibration | |

FIG. 2

302 Controllable Variables — Speed, Choke%, Valve Position, etc. →

304 Configuration Parameters — Well design, pump config., etc. →

306 Calibration Variables — GOR, WC, PI, Friction factor, etc. →

300 Forward ROM

Pressure, Temperature, Torque, Liquid Flowrate, Pump Leakage, etc. → 308 Predicted Variables

FIG. 3

EP 4 256 407 B1

FIG. 4

FIG. 5

FIG. 6

FIG. 7

FIG. 8

900

Speed, Torque, $P_i$, $P_d$,
[Q,WC,GOR] Measured
[PL] Predicted

| Calibration ROM |

Updated
Choke Opening

Updated Torque
Derating

| Inverse ROM |

[Q,WC,GOR,PL]
Predicted

## FIG. 9

1000

### Flow Estimate vs Measurement

- - - Q_STD
——— Adv regression

8000
7500
7000
6500
6000
5500
5000
4500
4000
3500

3/3/2018
9:21

3/3/2018
21:21

3/4/2018
9:21

## FIG. 10

1100

### Water Cut Estimate vs Measurement

- - - WC_STD
——— Adv regression

30
20
10
0
-10
-20
-30

3/3/2018
9:21

3/3/2018
21:21

3/4/2018
9:21

## FIG. 11

FIG. 12

FIG. 13

1400

FIG. 14

FIG. 15

FIG. 16

FIG. 17

EP 4 256 407 B1

1800

DOE
Simulation

ROM
Builder
1802

Predictor Variables
(Calibration measurements
and normal measurements)

Adjuster 1808

Adjusted
Predictor
Variables

Calibration ROM 1804

Calibration ROM 1806

Quasi Static
Parameters

Optimizer 1810

FIG. 18

FIG. 19

EP 4 256 407 B1

2000

```
                                    ┌──────────┐
                                    │   ROM    │
                                    │ Builder  │
                                    │   2002   │
                                    └────┬─────┘
                                         │                          Normal
                                         │                       Measurements
                                         ▼                            │
Predictor Variables                 ┌──────────┐   ┌──────────────┐   ▼   ┌──────────────┐
(Calibration measurements           │Calibration│  │Parameterized │      │Deconvolution │
and normal measurements) ─────────▶ │  ROMs    │──▶│Filter Function│────▶│    2008      │──▶ Predicted
                                    │   2004   │   │    2006      │      │              │    Response
                                    └──────────┘   └──────────────┘      └──────────────┘
                                     Quasi Static      Filtered
                                     Parameters       Quasi Static
                                                      Parameters
```

# FIG. 20

FIG. 21

FIG. 22

EP 4 256 407 B1

FIG. 23

FIG. 24

EP 4 256 407 B1